# EUROPEAN PATENT SPECIFICATION

(11) **EP 4 554 197 B1**
(45) Date of publication and mention of the grant of the patent: **02.12.2026**
(21) Application number: 23835682.8
(22) Date of filing: 18.05.2023
(51) Int. Cl.: G06F 1/16

(54) **ROLLABLE ELECTRONIC DEVICE COMPRISING BUTTON STRUCTURE**
AUFROLLBARE ELEKTRONISCHE VORRICHTUNG MIT KNOPFSTRUKTUR
DISPOSITIF ÉLECTRONIQUE ENROULABLE COMPRENANT UNE STRUCTURE DE BOUTON

(30) Priority: 07.07.2022 KR 20220083723; 19.07.2022 KR 20220089133
(43) Date of publication of application: 14.05.2025
(73) Proprietor: Samsung Electronics Co., Ltd., Suwon-si, Gyeonggi-do 16677 (KR)
(72) Inventor: CHUNG, Jaewoong, Suwon-si Gyeonggi-do 16677 (KR); LEE, Junghun, Suwon-si Gyeonggi-do 16677 (KR); PARK, Seonkeun, Suwon-si Gyeonggi-do 16677 (KR); LEE, Sunghoon, Suwon-si Gyeonggi-do 16677 (KR)
(74) Representative: Gulde & Partner
(86) International application number: PCT/KR2023/006800
(87) International publication number: WO 2024/010213

(56) References cited:
- WO-A1-2016/065482
- KR-A- 20210 054 875
- KR-A- 20220 005 741
- KR-A- 20220 078 451
- KR-B1- 102 391 961
- US-A1- 2021 135 492

## Description

### [Technical Field]

The invention relates to a button structure and a rollable electronic device including the same.

### [Background Art]

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with various integrated functions, including an entertainment function, such as playing video games, a multimedia function, such as replaying music/videos, a communication and security function for mobile banking, and a scheduling or e-wallet function. These electronic devices have been downsized to be conveniently carried by users.

As mobile communication services extend up to multimedia service sectors, electronic devices require a larger display to allow users satisfactory use of multimedia services as well as voice call or text messaging services. This, however, trades off the trend of electronic devices being compact. An electronic device with two housings, wherein one housing is slidable with respect to the other housing, is disclosed in US 2021 / 135492 A1.

### [Detailed Description of the Invention]

### [Technical Solution]

According to the invention, an electronic device according to claim 1 is provided. Embodiments of the invention are presented in the dependent claims.

### [Brief Description of the Drawings]

The above and other aspects, features and advantages of certain embodiments of the present disclosure will be more apparent from the following detailed description, taken in conjunction with the accompanying drawings, in which:
FIG. 1 is a block diagram illustrating an example electronic device in a network environment according to various embodiments;
FIG. 2 is a diagram illustrating a state in which a second display area of a display is received in a housing according to various embodiments;
FIG. 3 is a diagram illustrating a state in which a second display area of a display is visible to the outside of a housing according to various embodiments;
FIG. 4 is an exploded perspective view illustrating an electronic device according to various embodiments;
FIG. 5A is a cross-sectional view taken along line A-A' of FIG. 2 according to various embodiments;
FIG. 5B is a cross-sectional view taken along line B-B' of FIG. 3 according to various embodiments;
FIG. 6 is a perspective view illustrating a driving structure according to various embodiments;
FIG. 7 is a perspective view illustrating an electronic device in a slide-in state and a button structure according to various embodiments;
FIG. 8 is a cross-sectional view taken along line A-A' of FIG. 7 according to various embodiments;
FIG. 9 is a perspective view illustrating an electronic device in a slide-out state and a button structure according to various embodiments;
FIG. 10 is a cross-sectional view taken along line B-B' of FIG. 9 according to various embodiments;
FIG. 11 is a perspective view illustrating a first button assembly and a first cover member according to various embodiments;
FIG. 12 is a perspective view illustrating a second button assembly and a second cover member according to various embodiments;
FIG. 13A is a perspective view illustrating a button driver of a button structure according to various embodiments;
FIG. 13B is a cross-sectional view taken along line C-C' of FIG. 13A according to various embodiments;
FIG. 14 is a cross-sectional view taken along line D-D' of FIG. 3 according to various embodiments;
FIG. 15 is a diagram illustrating example operations of a button structure and an electronic device according to various embodiments;
FIG. 16 is a diagram illustrating an electronic device including a button structure according to various embodiments; and
FIG. 17 is a diagram illustrating an electronic device including a button structure according to various embodiments.

### [Mode for Carrying out the Invention]

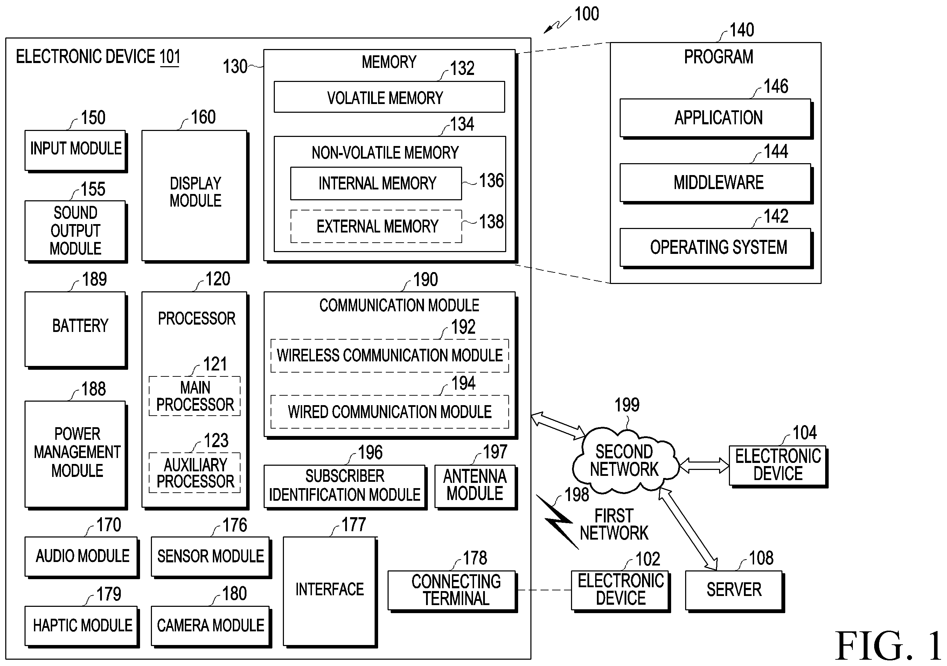

FIG. 1 is a block diagram illustrating an example electronic device in a network environment according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

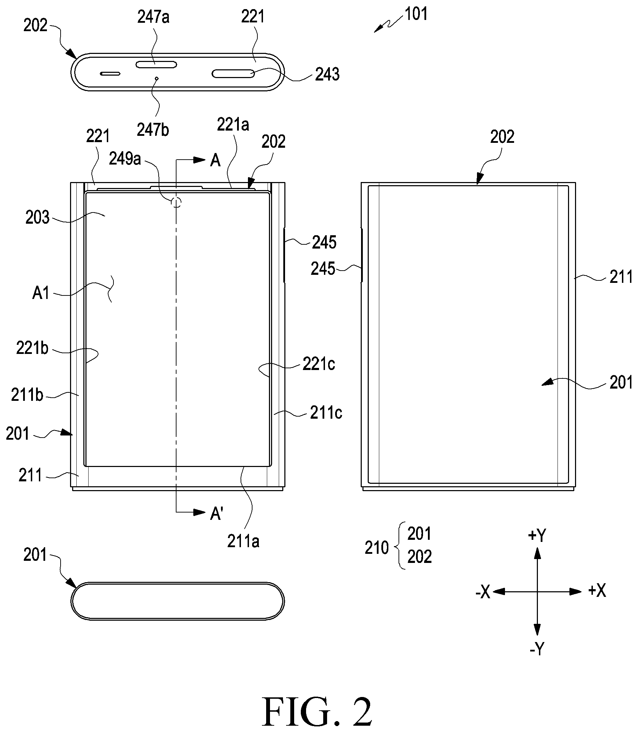

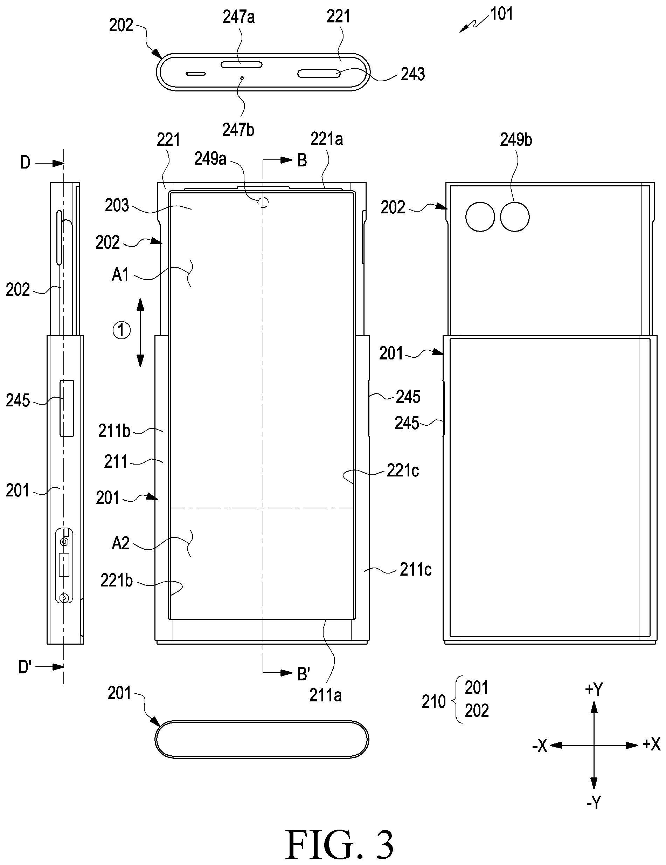

FIG. 2 is a diagram illustrating a state in which a second display area of a display is received in a housing according to various embodiments. FIG. 3 is a diagram illustrating a state in which a second display area of a display is visible to the outside of a housing according to various embodiments.

FIGS. 2 and 3 illustrate a structure in which the display 203 (e.g., flexible display or rollable display) is extended in the length direction (e.g., +Y direction) when the electronic device 101 is viewed from the front. However, the extending direction of the display 203 is not limited to one direction (e.g., +Y direction). For example, the extending direction of the display 203 may be changed in design to be extendable in the upper direction (+Y direction), right direction (e.g., +X direction), left direction (e.g., -X direction), and/or lower direction (e.g., -Y direction).

The state illustrated in FIG. 2 may be referred to as a slide-in state of the electronic device 101 or a state in which the second display area A2 of the display 203 is closed.

The state illustrated in FIG. 3 may be referred to as a slide-out state of the electronic device 101 or a state in which the second display area A2 of the display 203 is open.

Referring to FIGS. 2 and 3, the electronic device 101 may include a housing 210. The housing 210 may include a first housing 201 and a second housing 202 disposed to be movable relative to the first housing 201. According to an embodiment, the electronic device 101 may be interpreted as having a structure in which the first housing 201 is disposed to be slidable with respect to the second housing 202. According to an embodiment, the second housing 202 may be disposed to perform reciprocating motion by a predetermined distance in a predetermined direction with respect to the first housing 201, for example, a direction indicated by an arrow ①.

According to an embodiment, the second housing 202 may be referred to as a slide portion or a slide housing, and may be movable relative to the first housing 201. According to an embodiment, the second housing 202 may receive various electrical and electronic components, such as a circuit board or a battery.

According to an embodiment, the first housing 201 may receive a motor, a speaker, a sim socket, and/or a sub circuit board electrically connected with a main circuit board. The second housing 202 may receive a main circuit board on which electric components, such as an application processor (AP) and a communication processor (CP) are mounted.

According to an embodiment, the first housing 201 may include a first cover member 211 (e.g., a main case). The first cover member 211 may include a 1-1th sidewall 211a, a 1-2th sidewall 211b extending from the 1-1th sidewall 211a, and a 1-3th sidewall 211c extending from the 1-1th sidewall 211a and substantially parallel to the 1-2th sidewall 211b. According to an embodiment, the 1-2th sidewall 211b and the 1-3th sidewall 211c may be formed substantially perpendicular to the 1-1th sidewall 211a.

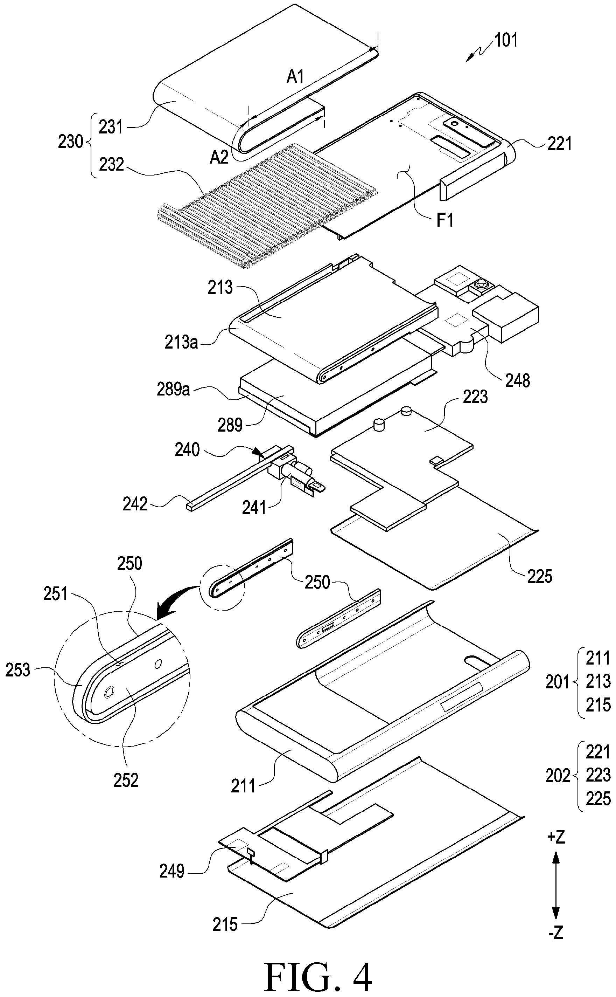

According to an embodiment, the 1-1th sidewall 211a, 1-2th sidewall 211b, and 1-3th sidewall 211c of the first cover member 211 may be formed to have a side opening (e.g., front opening) to receive (or surround) at least a portion of the second housing 202. For example, at least a portion of the second housing 202 may be surrounded by the first housing 201 and be slid in the direction parallel to the first surface (e.g., the first surface F1 of FIG. 4), e.g., arrow ① direction, while being guided by the first housing 201. According to an embodiment, the 1-1th sidewall 211a, the 1-2th sidewall 211b, and/or the 1-3th sidewall 211c of the first cover member 211 may be integrally formed. According to an embodiment, the 1-1th sidewall 211a, the 1-2th sidewall 211b, and/or the 1-3th sidewall 211c of the first cover member 211 may be formed as separate structures and be combined or assembled.

According to an embodiment, the first cover member 211 may be formed to surround at least a portion of the display 203. For example, at least a portion of the display 203 may be formed to be surrounded by the 1-1th sidewall 211a, the 1-2th sidewall 211b, and/or the 1-3th sidewall 211c of the first cover member 211.

According to an embodiment, the second housing 202 may include a second cover member 221 (e.g., a slide plate). The second cover member 221 may have a plate shape and include a first surface (e.g., the first surface F1 of FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a 2-1th sidewall 221a, a 2-2th sidewall 221b extending from the 2-1th sidewall 221a, and a 2-3th sidewall 221c extending from the 2-1th sidewall 221a and substantially parallel to the 2-2th sidewall 221b. According to an embodiment, the 2-2th sidewall 221b and the 2-3th sidewall 221c may be formed substantially perpendicular to the 2-1th sidewall 221a.

According to various embodiments, as the second housing 202 moves in a first direction (e.g., direction of arrow ①) parallel to the 2-2th sidewall 211b or the 2-3th sidewall 211c, the slide-in state and slide-out state of the electronic device 101 may be formed. In the slide-in state of the electronic device 101, the second housing 202 may be positioned at a first distance from the 1-1th sidewall 211a of the first housing 201. In the slide-out state of the electronic device 101, the second housing 202 may move to be positioned at a second distance larger than the first distance from the 1-1th sidewall 211a of the first housing 201. In an embodiment, in the slide-in state of the electronic device 101, the first housing 201 may be formed to surround a portion of the 2-1th sidewall 221a.

According to an embodiment, the electronic device 101 may have an intermediate state between the slide-in state (e.g., fully opened state) of FIG. 2 and the slide-out state (e.g., fully closed state) of FIG. 3. The distance between the 1-1th sidewall 211a and the 2-1th sidewall 221a in the intermediate state of the electronic device 101 may be shorter than the distance between the 1-1th sidewall 211a and the 2-1th sidewall 221a of the electronic device 101 in the fully open state and be longer than the distance between the 1-1th sidewall 211a and the 2-1th sidewall 221a of the electronic device 101 in the fully closed state. According to an embodiment, as at least a portion of the display 203 slides in the intermediate state of the electronic device 101, the area visible to the outside may vary. For example, in the intermediate state of the electronic device 101, the ratio of the width (length in the X direction) to the height (length in the Y direction) of the display 203 and/or the distance between the 1-1th sidewall 211a and the 2-1th sidewall 221a may be changed based on the slide of the electronic device 101.

According to an embodiment, the electronic device 101 may include a display 203, a key input device 245, a connector hole 243, audio modules 247a and 247b, or camera modules 249a and 249b. According to an embodiment, the electronic device 101 may further include an indicator (e.g., a light emitting diode (LED) device) or various sensor modules.

According to various embodiments, the display 203 may include a first display area A1 and a second display area A2 configured to be visible to the outside of the electronic device 101 based on the slide of the second housing 202. According to an embodiment, the first display area A1 may be disposed on the second housing 202. For example, the first display area A1 may be disposed on the second cover member 221 of the second housing 202. According to an embodiment, the second display area A2 may extend from the first display area A1, and the second display area A2 may be received in the first housing 201 or visible to the outside of the electronic device 101 as the second housing 202 slides relative to the first housing 201. According to an embodiment, as the electronic device 101 changes from the slide-in state to slide-out state, the display 203 may extend in the lower direction (e.g., -Y direction) of the electronic device 101. For example, in the slide-out state of the electronic device 101, the second display area A2 may be visible under the display 203 (e.g., in the - Y direction). According to an embodiment, as the electronic device 101 changes from the slide-out state to slide-in state, the display 203 may extend in the upper direction (e.g., +Y direction) of the electronic device 101. For example, in the slide-out state of the electronic device 101, the second display area A2 may be visible above the display 203 (e.g., in the +Y direction).

According to an embodiment, the second display area A2 may be received in the space positioned inside the first housing 201 or visible to the outside of the electronic device while being substantially guided by one area (e.g., the curved surface 213a of FIG. 4) of the first housing 201. According to an embodiment, the second display area A2 may move based on a slide of the second housing 202 in the first direction (e.g., the direction indicated by the arrow ①). For example, while the second housing 202 slides, a portion of the second display area A2 may be deformed into a curved shape in a position corresponding to the curved surface 213a of the first housing 201.

According to an embodiment, as viewed from above the second cover member 221 (e.g., front cover), if the electronic device 101 changes from the slide-in state to slide-out state (e.g., if the second housing 202 slides to extend from the first housing 201), the second display area A2 may be gradually be made visible to the outside of the first housing 201 and, together with the first display area A1, form a substantially flat surface. According to an embodiment, the display 203 may be coupled with or disposed adjacent to a touch detection circuit, a pressure sensor capable of measuring the strength (pressure) of touches, and/or a digitizer for detecting a magnetic field-type stylus pen. According to an embodiment, irrespective of the slide-in state or slide-out state of the electronic device 101, the visible portion of the second display area A2 may be positioned on a portion (e.g., the curved surface 213a of FIG. 4) of the first housing, and a portion of the second display area A2 may remain in the curved shape in the position corresponding to the curved surface 213a.

According to an embodiment, the key input device 245 may be positioned in an area of the housing 210 (e.g., the first housing 201 and/or second housing 202). Depending on the appearance and the state of use, the electronic device 101 may be designed to omit the illustrated key input device 245 or to include additional key input device(s). According to an embodiment, the electronic device 101 may include a key input device (not shown), e.g., a home key button or a touchpad disposed around the home key button. According to an embodiment, at least a portion of the key input device 245 may be disposed on the 1-1th sidewall 211a, the 1-2th sidewall 211b, or the 1-3th sidewall 211c of the first housing 201. According to an embodiment, at least a portion of the key input device 245 may be disposed on the 2-1th sidewall 221a, the 2-2th sidewall 221b, and/or the 2-3th sidewall 221c of the second housing 202.

According to an embodiment, the connector hole 243 may be omitted or may receive a connector (e.g., a universal serial bus (USB) connector) for transmitting and receiving power and/or data with an external electronic device. According to an embodiment (not shown), the electronic device 101 may include a plurality of connector holes 243, and some of the plurality of connector holes 243 may function as connector holes for transmitting/receiving audio signals with an external electronic device. In the illustrated embodiment, the connector hole 243 is disposed in the second housing 202, but is not limited thereto. For example, the connector hole 243 or a connector hole not shown may be disposed in the first housing 201.

According to an embodiment, the audio modules 247a and 247b may include at least one speaker hole 247a or at least one microphone hole 247b. One of the speaker holes 247a may be provided as a receiver hole for voice calls, and the other may be provided as an external speaker hole. The electronic device 101 may include a microphone for obtaining sound. The microphone may obtain external sound of the electronic device 101 through the microphone hole 247b. According to an embodiment, the electronic device 101 may include a plurality of microphones to detect the direction of sound. According to an embodiment, the electronic device 101 may include an audio module in which the speaker hole 247a and the microphone hole 247b are implemented as one hole or may include a speaker without the speaker hole 247a (e.g., a piezo speaker). According to an embodiment, the speaker hole 247a and the microphone hole 247b may be positioned in the first housing 201 and/or the second housing 202.

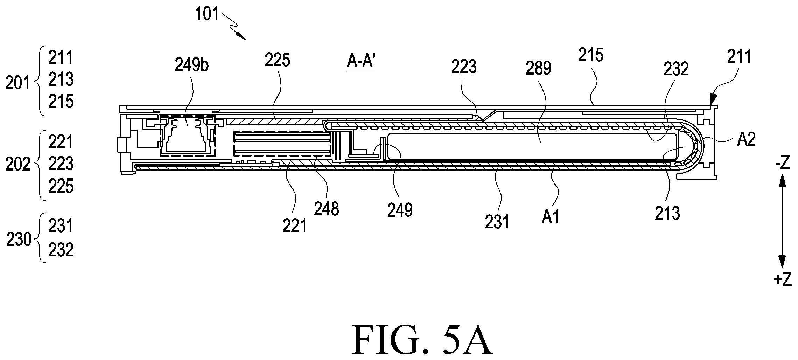

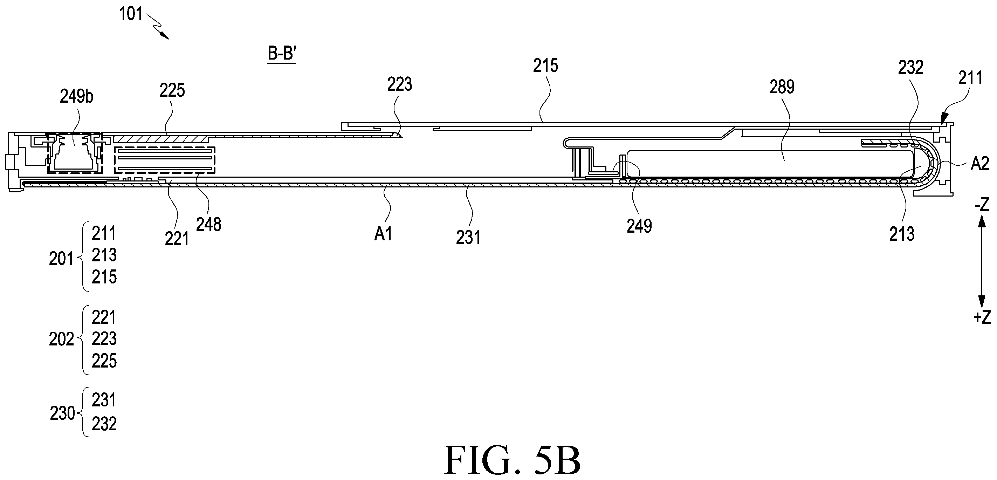

According to an embodiment, the camera modules 249a and 249b may include a first camera module 249a (e.g., a front camera) and a second camera module 249b (e.g., a rear camera) (e.g., the second camera module 249b of FIGS. 5A and 5B). According to an embodiment, the electronic device 101 may include at least one of a wide-angle camera, a telephoto camera, or a close-up camera. According to an embodiment, the electronic device 200 may measure the distance to the subject by including an infrared projector and/or an infrared receiver. The camera modules 249a and 249b may include one or more lenses, an image sensor, and/or an image signal processor. The first camera module 249a may be disposed to face in the same direction as the display 203. For example, the first camera module 249a may be disposed in an area around the first display area A1 or overlapping the display 203. When disposed in the area overlapping the display 203, the first camera module 249a may capture the subject through the display 203. According to an embodiment, the first camera module 249a may include an under display camera (UDC) that has a screen display area (e.g., the first display area A1) that may not be visible but hidden. According to an embodiment, the second camera module 249b may capture the subject in a direction opposite to the first display area A1. According to an embodiment, the first camera module 249a and/or the second camera module 249b may be disposed on the second housing 202. According to an embodiment, a plurality of second camera modules 249b may be formed to provide various arrays. For example, the plurality of second camera modules 249b may be arranged along a width direction (X-axis direction) that is substantially perpendicular to the sliding direction (e.g., Y-axis direction) of the electronic device 101. As another example, the plurality of second camera modules 249b may be arranged along the sliding direction (e.g., Y-axis direction) of the electronic device 101. As another example, the plurality of second camera modules 249b may be arranged along N * M rows and columns like a matrix.

According to an embodiment, the second camera module 249b is not visually exposed to the outside of the electronic device 101 in the slide-in state of the electronic device 101 and, in the slide-out state of the electronic device 101, may capture the outside of the electronic device 101. According to an embodiment, the second camera module 249b may capture the outside of the electronic device 101 in the slide-in state and slide-out state of the electronic device 101. For example, at least a portion (e.g., the first rear plate 215 and/or the second rear plate 225 of FIG. 4) of the housing 210 may be substantially transparent. The second camera module 249b may capture the outside of the electronic device 101 through the first rear plate 215 and/or the second rear plate 225.

According to an embodiment, an indicator (not shown) of the electronic device 101 may be disposed on the first housing 201 or the second housing 202, and the indicator may include a light emitting diode to provide state information about the electronic device 101 as a visual signal. The sensor module (not shown) of the electronic device 101 may produce an electrical signal or data value corresponding to the internal operation state or external environment state of the electronic device. The sensor module may include, for example, a proximity sensor, a fingerprint sensor, or a biometric sensor (e.g., an iris/face recognition sensor or a heartrate monitor (HRM) sensor). According to an embodiment, the sensor module may further include, e.g., at least one of a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor. According to an embodiment, the sensor module may be disposed in the first housing 201 and/or the second housing 202. For example, at least a portion of the sensor module may be positioned in the first housing 201, and another portion thereof may be positioned in the second housing 202.

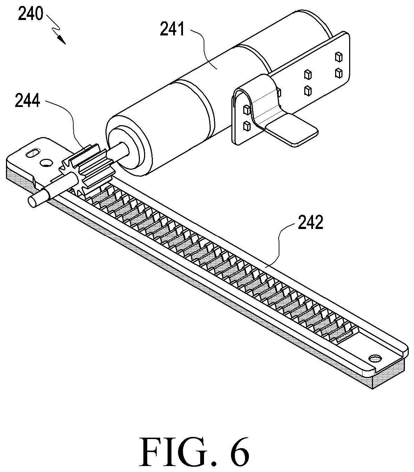

FIG. 4 is an exploded perspective view illustrating an electronic device according to various embodiments. FIG. 5A is a cross-sectional view taken along line A-A' of FIG. 2 according to various embodiments. FIG. 5B is a cross-sectional view taken along line B-B' of FIG. 3 according to various embodiments. FIG. 6 is a perspective view illustrating a driving structure according to various embodiments.

Referring to FIGS. 4, 5A, 5B, and/or 6, an electronic device 101 may include a first housing 201, a second housing 202, a display assembly 230, and a driving structure 240. The configuration of the first housing 201, the second housing 202, and the display assembly 230 of FIGS. 4, 5A, and/or 5B may be identical in whole or part to the configuration of the first housing 201, the second housing 202, and the display 203 of FIGS. 2 and/or 3. The embodiment of FIG. 2 and/or 3 may be partially combined with the embodiment of FIGS. 4, 5A, 5B and/or 6. According to an embodiment, the first housing 201 may include a first cover member 211 (e.g., the first cover member 211 of FIGS. 2 and 3), a frame 213, and a first rear plate 215.

According to an embodiment, the first cover member 211 may receive at least a portion of the frame 213 and receive a component (e.g., battery 289) positioned in the frame 213. According to an embodiment, the first cover member 211 may be formed to surround at least a portion of the second housing 202. According to an embodiment, the first cover member 211 may protect the components (e.g., the second circuit board 249 and the frame 213) positioned in the first housing 201 from external impact. According to an embodiment, the second circuit board 249 receiving the electronic component (e.g., the processor 120 and/or the memory 130 of FIG. 1) may be connected to the first cover member 211.

According to an embodiment, the frame 213 may be connected to the first cover member 211. For example, the frame 213 may be connected to the first cover member 211. The second housing 202 is movable relative to the first cover member 211 and/or the frame 213. According to an embodiment, the frame 213 may receive the battery 289. For example, the frame 213 may include a recess for receiving the battery 289. The frame 213 may be connected to the battery cover 289a and, together with the battery cover 289a, may surround at least a portion of the battery 289. According to an embodiment, the frame 213 may include a curved portion 213a facing the display assembly 230.

According to an embodiment, the first rear plate 215 may substantially form at least a portion of the exterior of the first housing 201 or the electronic device 101. For example, the first rear plate 215 may be coupled to the outer surface of the first cover member 211. According to an embodiment, the first rear plate 215 may provide a decorative effect on the exterior of the electronic device 101. The first rear plate 215 may be formed of at least one of metal, glass, synthetic resin, or ceramic.

According to an embodiment, the second housing 202 may include a second cover member 221 (e.g., the second cover member 221 of FIGS. 2 and 3), a rear cover 223, and a second rear plate 225.

According to an embodiment, the second cover member 221 may be connected to the first housing 201 through the guide rail 250 and, while being guided by the guide rail 250, reciprocate linearly in one direction (e.g., the direction of arrow ① in FIG. 3).

According to an embodiment, the second cover member 221 may support at least a portion of the display 203. For example, the second cover member 221 may include a first surface F1. The first display area A1 of the display 203 may be substantially positioned on the first surface F1 to maintain a flat panel shape. According to an embodiment, the second cover member 221 may be formed of a metal material and/or a non-metal (e.g., polymer) material. According to an embodiment, the first circuit board 248 receiving the electronic component (e.g., the processor 120 and/or the memory 130 of FIG. 1) may be connected to the second cover member 221. According to an embodiment, the second cover member 221 may protect the components (e.g., the first circuit board 248 and the rear cover 223) positioned in the second housing 202 from external impact.

According to an embodiment, the rear cover 223 may protect a component (e.g., the first circuit board 248) positioned on the second cover member 221. For example, the rear cover 223 may be connected to the second cover member 221 and may be formed to surround at least a portion of the first circuit board 248. According to an embodiment, the rear cover 223 may include an antenna pattern for communicating with an external electronic device. For example, the rear cover 223 may include a laser direct structuring (LDS) antenna.

According to an embodiment, the second rear plate 225 may substantially form at least a portion of the exterior of the second housing 202 or the electronic device 101. For example, the second rear plate 225 may be coupled to the outer surface of the second cover member 221. According to an embodiment, the second rear plate 225 may provide a decorative effect on the exterior of the electronic device 101. The second rear plate 225 may be formed of at least one of metal, glass, synthetic resin, or ceramic.

According to an embodiment, the display assembly 230 may include a display 231 (e.g., the display 203 of FIGS. 2 and/or 3) and a multi-bar structure 232 supporting the display 203. According to an embodiment, the display 231 may be referred to as a flexible display, a foldable display, and/or a rollable display. According to an embodiment, the first display area A1 of the display 231 may be supported by a rigid body. The second display area A2 may be supported by a bendable structure. For example, the first display area A1 may be supported by the first surface F1 of the second cover member 221 or a plate (not shown). The second display area A2 may be supported by the multi-bar structure 232.

According to an embodiment, the multi-bar structure 232 may be connected to or attached to at least a portion (e.g., the second display area A2) of the display 231. According to an embodiment, as the second housing 202 slides, the multi-bar structure 232 may move with respect to the first housing 201. In the slide-in state of the electronic device 101 (e.g., FIG. 2), the multi-bar structure 232 may be mostly received in the first housing 201 and may be positioned between the first cover member 211 and the second cover member 221. According to an embodiment, at least a portion of the multi-bar structure 232 may move corresponding to the curved surface 213a positioned at the edge of the frame 213. According to an embodiment, the multi-bar structure 232 may be referred to as a display supporting member or supporting structure and may be in the form of one elastic plate.

According to an embodiment, the driving structure 240 may move the second housing 202 relative to the first housing 201. For example, the drive structure 240 may include a motor 241 configured to generate a driving force for sliding the second housing 202 with respect to the first housing 201, for example. The driving structure 240 may include a gear 244 (e.g., a pinion) connected to the motor 241 and a rack 242 configured to mesh with the gear.

According to an embodiment, the housing in which the rack 242 is positioned and the housing in which the motor 241 is positioned may be different. According to an embodiment, the motor 241 may be connected to the second housing 202. The rack 242 may be connected to the first housing 201. According to an embodiment, the motor 241 may be connected to the first housing 201. The rack 242 may be connected to the second housing 202.

According to an embodiment, the motor 241 may be controlled by a processor (e.g., the processor 120 of FIG. 1). For example, the processor 120 may include a motor driver driving circuit and transfer a pulse width modulation (PWM) signal for controlling the speed of the motor 241 and/or the torque of the motor 241 to the motor 241. According to an embodiment, the motor 241 may be electrically coupled to a processor (e.g., the processor 120 of FIG. 1) positioned on the circuit board (e.g., the circuit board 204 of FIG. 4) using a flexible printed circuit board.

According to an embodiment, the second housing 202 may receive the first circuit board 248 (e.g., a main board). According to an embodiment, the processor, memory, and/or interface may be mounted on the first circuit board 248. The processor may include one or more of, e.g., a central processing unit, an application processor, a graphic processing device, an image signal processing, a sensor hub processor, or a communication processor. According to various embodiments, the first circuit board 248 may include a flexible printed circuit board type radio frequency cable (FRC). The first circuit board 248 may be disposed on at least a portion of the second cover member 221 and may be electrically connected to the antenna module and the communication module.

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment, the electronic device 101 may include a second circuit board 249 (e.g., a sub circuit board) spaced apart from the first circuit board 248 (e.g., a main circuit board) in the first housing 201. The second circuit board 249 may be electrically connected to the first circuit board 248 through a connection flexible board. The second circuit board 249 may be electrically connected with electric components disposed in an end area of the electronic device 101, such as the battery 289 or a speaker and/or a sim socket, and may transfer signals and power. According to an embodiment, the second circuit board 249 may receive a wireless charging antenna (e.g., a coil) or be connected to the wireless charging antenna. For example, the battery 289 may receive power from an external electronic device through the wireless charging antenna. As another example, the battery 289 may transfer power to the external electronic device by the wireless charging antenna.

According to an embodiment, the battery 289 may be a device for supplying power to at least one component of the electronic device 101. The battery 189 may include a primary cell which is not rechargeable, a secondary cell which is rechargeable, or a fuel cell. The battery 289 may be integrally or detachably disposed inside the electronic device 101. According to an embodiment, the battery 289 may be formed of a single embedded battery or may include a plurality of removable batteries. According to various embodiments, the battery 289 may be position on the frame 213. For example, the battery 289 may be surrounded by the frame 213 and the battery cover 289a. According to an embodiment, it may be positioned within the second housing 202 and is slidable along with the second housing 202.

According to an embodiment, the guide rail 250 may guide the movement of the multi-bar structure 232. For example, the multi-bar structure 232 may slide along the slit 251 formed in the guide rail 250. According to an embodiment, the guide rail 250 may be connected to the first housing 201. For example, the guide rail 250 may be connected to the first cover member 211 and/or the frame 213. According to an embodiment, the slit 251 may be referred to as a groove or recess formed in the inner surface of the guide rail 250.

According to an embodiment, the guide rail 250 may provide a force to the multi-bar structure 232 based on the driving of the motor 241.

According to an embodiment, when the electronic device 101 changes from the slide-in state to the slide-out state, the inner portion 252 of the guide rail 250 may provide a force to the multi-bar structure 232. The multi-bar structure 232 receiving the force may be moved along the slit 251 of the guide rail 250, and the second housing 202 may be slid to extend relative to the first housing 201. At least a portion of the display assembly 230 received between the first cover member 211 and the frame 213 may extend to the front surface.

According to an embodiment, when the electronic device 101 changes from the slide-out state to slide-in state, the outer portion 253 of the guide rail 250 may provide a force to the bent multi-bar structure 232. The multi-bar structure 232 receiving the force may be moved along the slit 251 of the guide rail 250, and at least a portion of the second housing 202 may be slid to be received in the first housing 201. At least a portion of the display assembly 230 may be received between the first cover member 211 and the frame 213.

Referring to FIG. 5A, in the slide-in state of the electronic device 101, at least a portion of the second housing 202 may be disposed to be received in the first housing 201. As the second housing 202 is disposed to be received in the first housing 201, the overall volume of the electronic device 101 may be reduced. According to an embodiment, when the second housing 202 is received in the first housing 201, the size of the visible area of the display 231 may be minimized or reduced. For example, if the second housing 202 is completely received in the first housing 201, the first display area A1 of the display 231 may be visible, and at least a portion (e.g., a portion along the -Z axis) of the second display area A2 may be disposed between the battery 289 and the first rear plate 215.

Referring to FIG. 5B, in the slide-out state of the electronic device 101, at least a portion of the second housing 202 may protrude from the first housing 201. As the second housing 202 is disposed to protrude from the first housing 201, the overall volume of the electronic device 101 may be increased. According to an embodiment, if the second housing 202 protrudes from the first housing 201, at least a portion of the second display area A2 of the display 231, together with the first display area A1, may be visible to the outside of the electronic device 101.

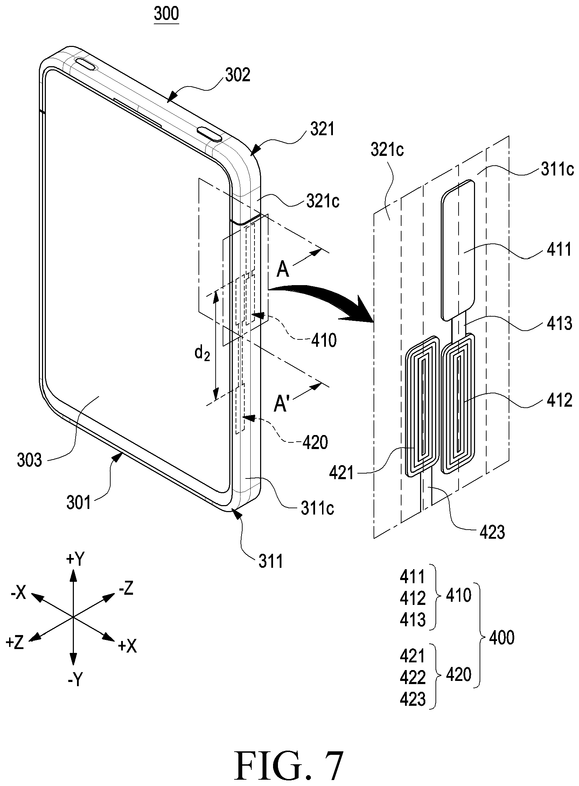

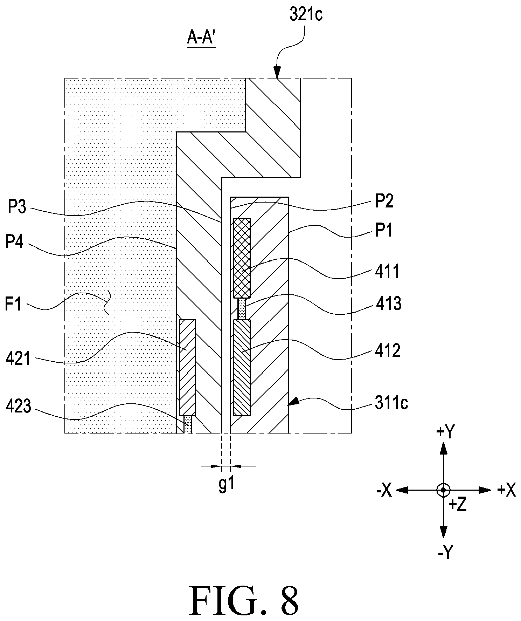

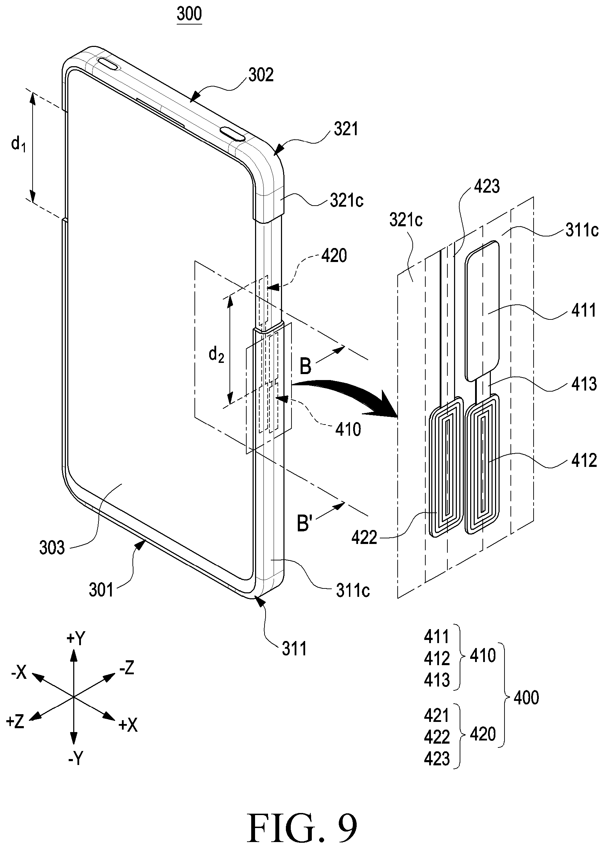

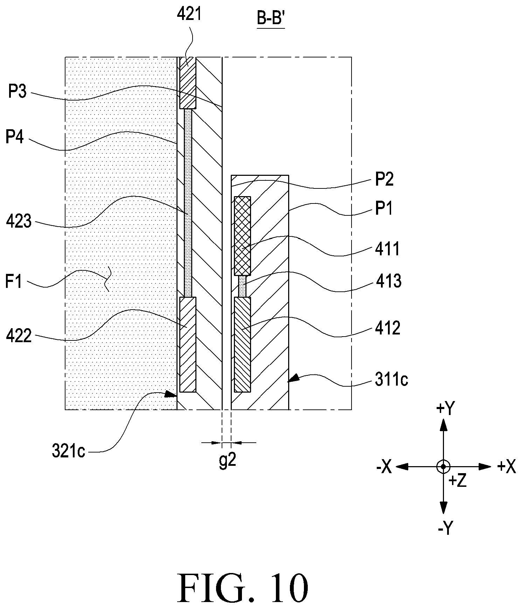

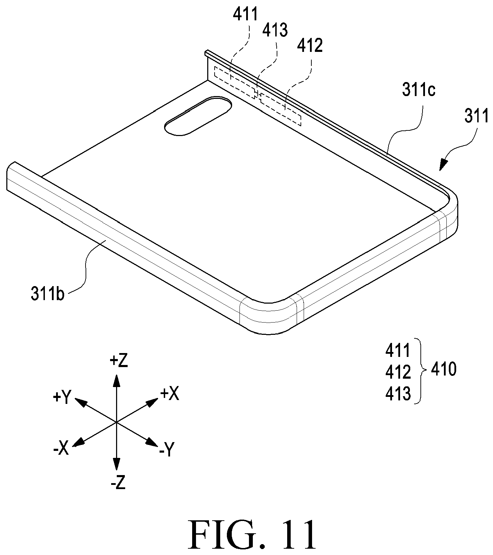

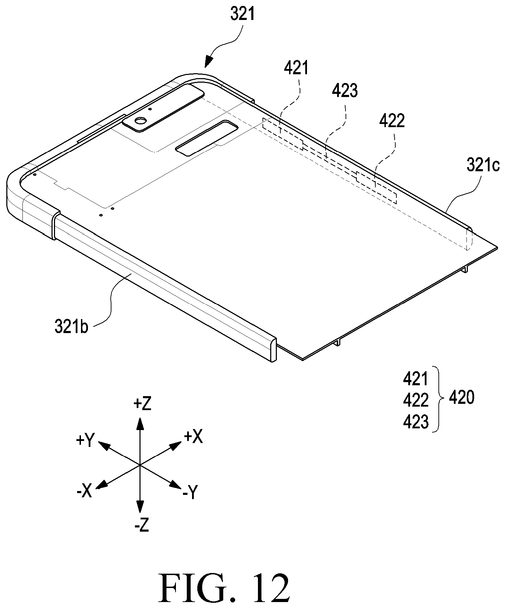

FIG. 7 is a perspective view illustrating an electronic device in a slide-in state and a button structure according to various embodiments. FIG. 8 is a cross-sectional view taken along line A-A' of FIG. 7 according to various embodiments. FIG. 9 is a perspective view illustrating an electronic device in a slide-out state and a button structure according to various embodiments. FIG. 10 is a cross-sectional view taken along line B-B' of FIG. 9 according to various embodiments. FIG. 11 is a perspective view illustrating a first button assembly and a first cover member according to various embodiments. FIG. 12 is a perspective view illustrating a second button assembly and a second cover member according to various embodiments.

Referring to FIGS. 7, 8, 9, 10, 11 and 12 (which may be referred to as FIGS. 7 to 12), in an embodiment, an electronic device 300 may include a first housing 301, a second housing 302, a display 303, and a button structure 400. The electronic device 300 of FIGS. 7 and 9 may be identical in whole or part to the configuration of the electronic device 100 of FIG. 1 and/or the electronic device 101 of FIGS. 2 to 5B. The display 303 of FIGS. 7 and 9 may be identical in whole or part to the configuration of the display module 160 of FIG. 1, the display 203 of FIGS. 2 and 3, and/or the display 231 of FIGS. 4 to 5B. According to an embodiment, the configuration of the button structure 400 of FIGS. 7 to 10 may be identical in whole or part to the configuration of the configuration of the key input device 245 of FIGS. 2 and 3.

According to an embodiment, the button structure 400 may be positioned in at least one area of the first housing 301 and/or the second housing 302. According to an embodiment, the button structure 400 may be disposed in the right (+X direction) area of the first housing 301 and the second housing 302. However, the position of the button structure 400 is not limited to the above-described area. For example, the at least one button structure 400 may be disposed in the left (-X direction) area or in the left (-X direction) and right (+X direction).

According to an embodiment, the button structure 400 may include a first button assembly 410 disposed in one area of a first cover member 311 (e.g., the first cover member 211 of FIGS. 2 to 5B) of the first housing 301. According to an embodiment, the button structure 400 may include a second button assembly 420 disposed in one area of the second cover member 321 (e.g., the second cover member 221 of FIGS. 2 to 5B) of the second housing 302. According to an embodiment, the first button assembly 410 may be disposed on the 1-3th sidewall 311c (e.g., the 1-3th sidewall 211c of FIGS. 2 and 3) of the first cover member 311. According to an embodiment, the second button assembly 420 may be disposed on the 2-3th sidewall 321c (e.g., the 2-3th sidewall 221c of FIGS. 2 and 3) of the second cover member 321 (e.g., the first cover member 221 of FIGS. 2 to 5B).

Referring to FIGS. 8 and 10, in an embodiment, an air gap may be formed in at least a partial area between the first cover member 311 and the second cover member 321. According to an embodiment, in the slide-in state of the electronic device 300 of FIG. 8, the 1-3th sidewall 311c of the first cover member 311 and the 2-3th sidewall 321c of the second cover member 321 may be spaced apart from each other by a first gap g1. According to an embodiment, in the slide-out state of the electronic device 300 of FIG. 10, the 1-3th sidewall 311c and the 2-3th sidewall 321c may be spaced apart from each other by a second gap g2. For example, the first gap g1 and the second gap g2 may be substantially the same as each other.

According to an embodiment, the first button assembly 410 may be disposed in the 1-3th sidewall 311c of the first cover member 311. According to an embodiment, the first button assembly 410 may include a sensor module 411, a first coil 412, and a first connection member 413.

Referring to FIG. 8, in an embodiment, the 1-3th sidewall 311c may include a first side surface P1 (+X direction surface) facing the outside of the electronic device 300 and a second side surface P2 (-X direction surface) opposite the first side surface P1 and facing the 2-3th sidewall 321c. For example, the first side surface P1 and/or the second side surface P2 of the 1-3th sidewall 311c may form at least a portion of the exterior of the electronic device 300. According to an embodiment, the sensor module 411, the first coil 412, and/or the first connection member 413 may be disposed further adjacent to the second side surface P2 than the first side surface P1 of the 1-3th sidewall 311c. However, the position of the sensor module 411, the first coil 412, and/or the first connection member 413 is not limited to the above-described position. For example, the sensor module 411, the first coil 412, and/or the first connection member 413 may be disposed in an intermediate area between the first side surface P1 and the second side surface P2, or may be disposed further adjacent to the second side surface P2 than the first side surface P1.

In an embodiment, the first button assembly 410 (e.g., the sensor module 411, the first coil 412, and/or the first connection member 413) may be accommodated in a mounting area within the 1-3th sidewall 311c. For example, the mounting area may be an accommodation space spaced apart from the second side surface P2. For example, the first coil 412 may be printed or deposited on one surface of the mounting area, or may be inserted into the mounting area. For example, the first button assembly 410 may not be exposed to the outside through the second side surface P2. For example, the first button assembly 410 may be coupled to and integrated with the mounting area when the first cover member (e.g., the 1-3th sidewall 311c) is manufactured. However, the mounting area is not limited to the accommodation space spaced apart from the second side surface P2. For example, the mounting area may be a recess in which a portion of the second side surface P2 is recessed in the direction (+X direction) of the first side surface P1. For example, the first button assembly 410 may not be exposed to the outside by a cover member covering the recess.

Referring to FIGS. 7 to 11, according to an embodiment, the sensor module 411 and the first coil 412 may be disposed side by side in the length direction (Y-axis direction) of the 1-3th sidewall 311c. For example, the sensor module 411 may be disposed above (+Y direction) the first coil 412. However, the positional relationship between the sensor module 411 and the first coil 412 is not limited to the above-described arrangement. For example, the sensor module 411 may be disposed under (-Y direction) the first coil 412. For example, the sensor module 411 may be disposed under (-Y direction) the first coil 412. According to an embodiment, the sensor module 411 and the first coil 412 may be spaced apart from each other in the length direction (Y-axis direction) of the 1-3th sidewall 311c. However, the direction in which the sensor module 411 and the first coil 412 are arranged is not limited to the length direction of the 1-3th sidewall 311c. In an embodiment, the sensor module 411 and the first coil 412 may be spaced apart from each other in the height direction (Z-axis direction) of the 1-3th sidewall 311c and/or the thickness direction (X-axis direction) of the 1-3th sidewall 311c. In an embodiment, the sensor module 411 may at least partially overlap the first coil 412 in the thickness direction (X-axis direction).

According to an embodiment, the sensor module 411 may be configured to generate an instantaneous voltage when pressed. For example, the sensor module 411 may be a piezoelectric sensor including a piezoelectric element. For example, the sensor module 411 may include at least one electrical or electronic component. For example, the sensor module 411 may include a thin film piezoelectric element. According to an embodiment, the instantaneous voltage of the sensor module 411 may be applied to the first coil 412 electrically connected to the sensor module 411.

Referring to FIGS. 7 to 10, according to an embodiment, the first coil 412 may be disposed to face the second coil 421 in the slide-in state of the electronic device 300. According to an embodiment, the first coil 412 may be disposed to face the third coil 422 in the slide-out state of the electronic device 300. According to an embodiment, in the slide-in state or the slide-out state of the electronic device 300, the first coil 412 may at least partially overlap the second coil 421 or the third coil 422 in the thickness direction (X-axis direction). According to an embodiment, the first coil 412 may be electromagnetically coupled to the second coil 421 or the third coil 422 facing each other. According to an embodiment, the first coil 412 may be a primary coil. For example, the first coil 412 may generate a magnetic field when a voltage is applied from the sensor module 411. For example, the magnetic field of the first coil 412 may generate an induced electromotive force in the electromagnetically coupled second coil 421 or third coil 422.

Referring to FIGS. 7 and 9, according to an embodiment, the first coil 412 may be a coil member in which a conducting line is spirally wound. According to an embodiment, the first coil 412 may be an air-core coil. According to an embodiment, the first coil 412 may have a form in which the length in the length direction (Y-axis direction) of the 1-3th sidewall 311c is larger than the length in the height direction (Z-axis direction) of the 1-3th sidewall 311c. According to an embodiment, the first coil 412 may be rectangular, but is not limited thereto. For example, the first coil 412 may have various shapes such as an elliptical shape, a circular shape, or a polygon (e.g., a pentagon or a hexagon). According to an embodiment, the first coil 412 may be a single coil member, but is not limited thereto. For example, the first coil 412 may include a plurality of coil members.

In an embodiment, the first connection member 413 may electrically connect the sensor module 411 and the first coil 412. For example, at least a portion of the first connection member 413 may be disposed between the sensor module 411 and the first coil 412. For example, the first connection member 413 may be connected to one end portion (-Y direction end portion) of the sensor module 411 and one end portion (+Y direction end portion) of the first coil 412. For example, the first connection member 413 may be a conductive wire member. According to an embodiment, the first connection member 413 may be a strip-type flexible printed circuit board. According to an embodiment, the first connection member 413 may include at least one electrical or electronic component.

According to an embodiment, the second button assembly 420 may include a second coil 421, a third coil 422, and a second connection member 423.

Referring to FIG. 10, in an embodiment, the 2-3th sidewall 321c may include a third side surface P3 (+X direction surface) facing the second side surface P2 and a fourth side surface P4 (-X direction surface) positioned opposite to the third side surface P3. For example, the third side surface P3 and/or the fourth side surface P4 of the 2-3th sidewall 321c may form at least a portion of the exterior of the electronic device 300. According to an embodiment, the second coil 421, the third coil 422, and/or the second connection member 423 may be disposed further adjacent to the fourth side surface P4 than the third side surface P3 of the 2-3th sidewall 321c. However, the position of the second coil 421, the third coil 422, and/or the second connection member 423 are not limited to the above-described position. For example, the second coil 421, the third coil 422, and/or the second connection member 423 may be disposed in an intermediate area between the third side surface P3 and the fourth side surface P4, or may be disposed further adjacent to the fourth side surface P4 than the third side surface P3.

In an embodiment, the second button assembly 420 (e.g., the second coil 421, the third coil 422, and/or the second connection member 423) may be accommodated in a mounting area in the 2-3th sidewall 321c. For example, the mounting area may be an accommodation space spaced apart from the fourth side surface P4. For example, the second coil 421 and/or the third coil 422 may be printed or deposited on one surface of the mounting area, or may be inserted into the mounting area. For example, the second button assembly 420 may not be exposed to the outside through the fourth side surface P4. For example, the second button assembly 420 may be coupled to and integrated with the mounting area when the second cover member (e.g., the 2-3th sidewall 321c) is manufactured. However, the mounting area is not limited to an accommodation space spaced apart from the fourth side surface P4. For example, the mounting area may be a recess in which a portion of the fourth side surface P4 is recessed in the direction (+X direction) of the third side surface P3. For example, the second button assembly 420 may not be exposed to the outside by the cover member covering the recess.

Referring to FIGS. 7 to 12, according to an embodiment, the second coil 421 and the third coil 422 may be disposed to be spaced apart from each other in the length direction (Y-axis direction) of the 2-3th sidewall 321c. According to an embodiment, the second coil 421 may be spaced apart from the upper portion (+Y direction) of the third coil 422 by a separation distance d2. For example, the separation distance d2 is a reference distance in the length direction (Y-axis direction) of the 2-3th sidewall 321c, and may be a distance from one end portion of the third coil 422 facing one end portion of the second coil 421 to the other end portion of the second coil 421. For example, the length direction of the 2-3th sidewall 321c may be substantially the same as the sliding direction (e.g., the direction of arrow ① or the Y-axis direction of FIG. 3) of the second housing 302. For example, the second coil 421 and the third coil 422 may be aligned with each other in the length direction (Y-axis direction) of the 2-3th sidewall 321c.

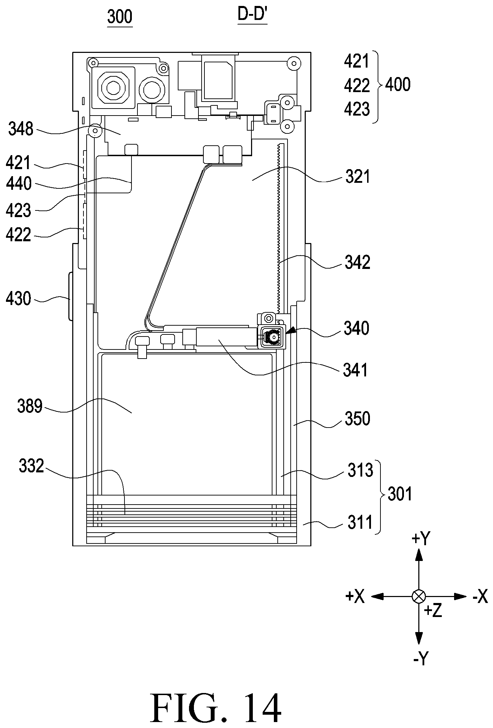

However, the positions of the second coil 421 and the third coil 422 are not limited to being disposed in the 2-3th sidewall 321c. In an embodiment, the second coil 421 and/or the third coil 422 may be mounted on another component that slides together with the second cover member 321. In an embodiment, the second coil 421 and/or the third coil 422 may be mounted on a rear cover (e.g., the rear cover 223 of FIG. 4) of the second housing 302. In an embodiment, the second coil 421 and/or the third coil 422 may be mounted on a first circuit board (e.g., the first circuit board 248 of FIG. 4 or the first circuit board 348 of FIG. 14) in the second housing 302. In this case, the second coil 421 and/or the third coil 422 may be electrically connected to a first circuit board (e.g., the first circuit board 248 of FIG. 4 or the first circuit board 348 of FIG. 14). For example, the rear cover (e.g., the rear cover 223 of FIG. 4) and/or the first circuit board (e.g., the first circuit board 248 of FIG. 4 and/or the first circuit board 348 of FIG. 14) may include an extension area extending toward the first button assembly 410 (e.g., in the +X axis direction). For example, the second coil 421 and/or the third coil 422 may be disposed in the extension area. The above-described embodiments regarding the positions of the second coil 421 and the third coil 422 may be combined with each other. For example, the second coil 421 may be disposed in the 2-3th sidewall 321c, and the third coil 422 may be mounted on the rear cover (e.g., the rear cover 223 of FIG. 4) or a portion of the first circuit board (e.g., the first circuit board 248 of FIG. 4 or the first circuit board 348 of FIG. 14).

Referring to FIGS. 7 and 8, in an embodiment, the second coil 421 may be disposed to face the first coil 412 in the slide-in state of the electronic device 300. Referring to FIGS. 9 and 10, in an embodiment, the third coil 422 may be disposed to face the first coil 412 in the slide-out state of the electronic device 300. For example, in the slide-in state or the slide-out state of the electronic device 300, the second coil 421 or the third coil 422 may at least partially overlap the first coil 412 in the thickness direction (X-axis direction) of the 2-3th sidewall 321c. In an embodiment, the separation distance d2 between the second coil 421 and the third coil 422 may be substantially the same as the sliding distance d1 illustrated in FIG. 9. According to an embodiment, the second coil 421 and the third coil 422 may be electromagnetically coupled to the first coil 412 while facing the first coil 412. According to an embodiment, the second coil 421 and/or the third coil 422 may be a secondary coil. For example, the first coil 412 may subject the second coil 421 and/or the third coil 422 to electromagnetic induction with the magnetic field generated by the instantaneous voltage. According to an embodiment, the second coil 421 and/or the third coil 422 may be a coil member in which a conducting line is spirally wound. According to an embodiment, the second coil 421 and/or the third coil 422 may be an air-core coil. According to an embodiment, the second coil 421 and/or the third coil 422 may have a form in which the length in the length direction (Y-axis direction) of the 1-3th sidewall 311c may be larger than the length in the height direction (Z-axis direction) of the 1-3th sidewall 311c. According to an embodiment, the second coil 421 and/or the third coil 422 may be rectangular, but is not limited thereto. For example, the second coil 421 and/or the third coil 422 may have various shapes such as an elliptical shape, a circular shape, or a polygon (e.g., a pentagon or a hexagon). According to an embodiment, the second coil 421 and the third coil 422 may be substantially the same as each other. According to an embodiment, each of the second coil 421 and the third coil 422 may be a single coil member, but is not limited thereto. For example, each of the second coil 421 and/or the third coil 422 may include a plurality of coil members.

In an embodiment, the second connection member 423 may electrically connect the second coil 421 and the third coil 422. For example, at least a portion of the second connection member 423 may be disposed between the second coil 421 and the third coil 422. For example, the second connection member 423 may be connected to one end portion (-Z direction end portion) of the second coil 421 and one end portion (+Z direction end portion) of the third coil 422. According to an embodiment, the second connection member 423 may be a strip-type flexible printed circuit board. For example, the second connection member 423 may include at least one electrical or electronic component.

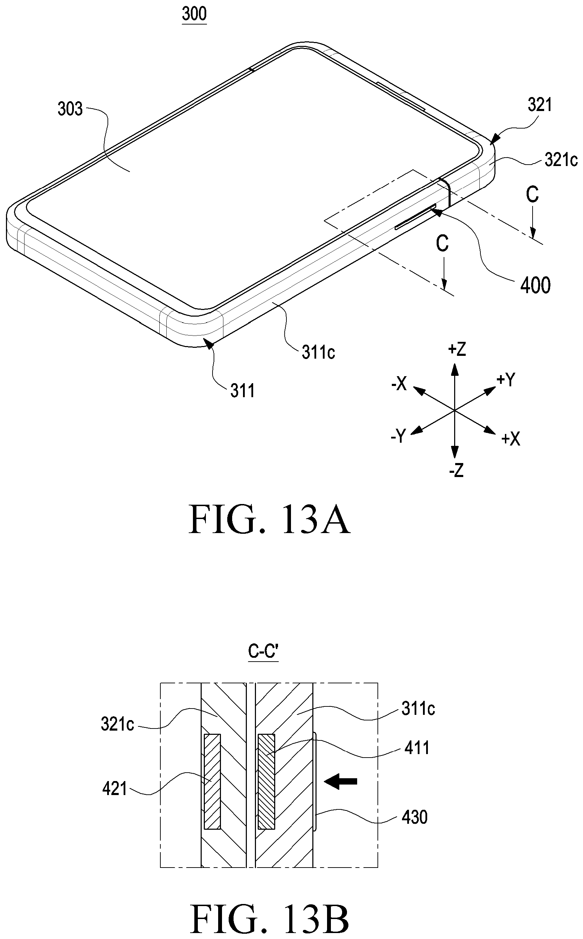

FIG. 13A is a perspective view illustrating a button driver of a button structure according to various embodiments. FIG. 13B is a cross-sectional view taken along line C-C' of FIG. 13A according to various embodiments. FIG. 14 is a cross-sectional view taken along line D-D' of FIG. 3 according to various embodiments. The embodiments of FIGS. 13A, 13B and 14 may be combined with the embodiments of FIGS. 1 to 14, and FIGS. 15 to 17. The embodiments of FIGS. 13A to 14 are not inseparably combined with the embodiments of FIGS. 7 to 12.

The configuration of the electronic device 300 of FIGS. 13A and 14 may be identical in whole or part to the configuration of the configuration of the electronic device 300 of FIGS. 7 and 9. The configuration of the first housing 301 of FIGS. 13 and 14 may be identical in whole or part to the configuration of the configuration of the first housing 301 of FIGS. 7 and 9. The configuration of the second cover member 321 of FIGS. 13A, 13B, and 14 may be identical in whole or part to the configuration of the configuration of the second cover member 321 of FIGS. 7, 9, and 12. The configuration of the button structure 400 of FIG. 13A may be identical in whole or part to the configuration of the configuration of the button structure 400 of FIGS. 7 and 9. The configuration of the multi-bar structure 323, the first circuit board 348, and the battery 389 of FIG. 14 may be the same in whole or part as the configuration of the multi-bar structure 232, the first circuit board 248, and the battery 289 of FIGS. 4 to 5B. The configuration of the guide rail 350 of FIG. 14 may be identical in whole or part to the configuration of the configuration of the guide rail 250 of FIGS. 5A and 5B. The configuration of the driving structure 340 of FIG. 14 may be identical in whole or part to the configuration of the configuration of the driving structure 240 of FIGS. 4 and 6.

Referring to FIGS. 13A and 13B, according to an embodiment, the button structure 400 may include a button driver 430 that primarily receives a "click input" of the user. For example, the button driver 430 may guide the user to the position to be click-input. For example, "click input" may indicate that a partial area of the outer surface of the button structure 400 is pressed by, e.g., the user so that a click signal is input to the electronic device 300. According to an embodiment, the user may press a partial area (e.g., the button driver 430) corresponding to the position of the sensor module 411 (e.g., the sensor module 411 of FIGS. 8 to 11) from the first side surface P1 (e.g., the first side surface P1 of FIGS. 8 and 10) of the 1-3th sidewall 311c (e.g., the 1-3th sidewall 311c of FIGS. 7 to 11) toward the sensor module 411 (e.g., the -X direction or the arrow direction of FIG. 13) to make a click input.

According to an embodiment, the button driver 430 may be disposed in a partial area of the first side surface P1 of the 1-3th sidewall 311c corresponding to the position of the sensor module 411. For example, the button driver 430 may be aligned with and/or at least partially overlap the sensor module 411 with respect to the X-axis. The button driver 430 may have various forms capable of displaying the position of the click input. According to an embodiment, the length of the button driver 430 in the Y-axis direction may be larger than the length of the button driver 430 in the X-axis direction. According to an embodiment, the button driver 430 may have a form in which a partial area of the first side surface P1 protrudes. For example, the button driver 430 may be a recess or a groove where a partial area of the first side surface P1 is recessed. For example, the button driver 430 may be formed by etching, printing, or coating a partial area on the first side surface P1.

Referring to FIG. 14, in an embodiment, the button structure 400 may include a third connection member 440. According to an embodiment, the third connection member 440 may electrically connect the second button assembly 420 and the first circuit board 348. For example, the third connection member 440 may be a flexible printed circuit board. According to an embodiment, one end of the third connection member 440 may be connected to a processor (e.g., the processor 120 of FIG. 1) positioned on the first circuit board 348. According to an embodiment, the processor (e.g., the processor 120 of FIG. 1) may receive an electrical signal from the second button assembly 420 using the third connection member 440. For example, the processor (e.g., the processor 120 of FIG. 1) may detect a click input based on the electrical signal.

According to an embodiment, the second button assembly 420 may include a processing circuit (not shown) that detects a variation in the voltage of the second coil 421 and the third coil 422 and processes the same into an electrical signal. For example, the variation in voltage may be transferred to the processor (e.g., the processor 120 of FIG. 1) through the third connection member 440 as an electrical signal. For example, the processing circuit may include a transmission/reception circuit for exchanging electrical signals with the processor (e.g., the processor 120 of FIG. 1). For example, the third connection member 440 may be connected to a portion of the second button assembly 420. For example, the processing circuit may be disposed adjacent to a partial area of the second button assembly 420 to which the third connection member 440 is connected. For example, the third connection member 440 may be connected to the second connection member 423 to transmit and receive electrical signals to and from the processing circuit. However, the connection relationship between the third connection member 440 and the second button assembly 420 is not limited to the above-described example. For example, the third connection member 440 may be connected to at least one of the second coil 421, the third coil 422, or the second connection member 423. According to an embodiment, the third connection member 440 may be connected to the second coil 421 to transmit and receive an electrical signal to and from the processing circuit. However, the position of the processing circuit is not limited to the partial area of the second button assembly 420. For example, the processing circuit may be disposed on the third connection member 440.

Hereinafter, a structure in which the electronic device 300 according to embodiments of the disclosure detects a click input using the button structure 400 is described.

According to an embodiment, the sensor module 411 may be activated by receiving a force (pressure) larger than or equal to a first designated force. For example, the first setting force may be a minimum force that generates an instantaneous voltage to the piezoelectric element of the sensor module 411. For example, the user may perform a click input by applying a force (pressure) larger than or equal to the first designated force to one area (e.g., the button driver 430) of the button structure 400. For example, the first setting force may be customized to the user. For example, the user may set or change the numerical value of the minimum force according to an individual usage method and preference using software of the electronic device 300. In an embodiment, the "click input" may include touching the button driver 430 to input a click signal to the electronic device 300 by the user. According to an embodiment, the sensor module 411 may include a pressure sensor capable of measuring the pressure of a touch and a touch sensing circuit.

According to an embodiment, the electronic device 300 may detect a click signal using a change in the voltage of the second coil 421 or the third coil 422. For example, an external force toward the sensor module 411 may be applied to an area (e.g., the button driver 430) of the 1-3th sidewall 311c corresponding to the sensor module 411. The external force may be transferred to the sensor module 411 through the 1-3th sidewall 311c. For example, at least a portion of the 1-3th sidewall 311c may include an elastically deformable material. If an external force is transferred to the piezoelectric element disposed in the sensor module 411, an instantaneous voltage of the piezoelectric element may be generated. The voltage may be applied to the first coil 412 electrically connected to the sensor module 411 and an electric field may be generated. For example, when the electronic device 300 is in the slide-in state, an induced electromotive force due to the electric field of the first coil 412 may be generated in the second coil 421 electromagnetically connected to the first coil 412. For example, when the electronic device 300 is in the slide-out state, an induced electromotive force due to the electric field of the first coil 412 may be generated in the third coil 422 electromagnetically connected to the first coil 412. For example, the processing circuit disposed in the second button assembly 420 may measure a change in the voltage of the second coil 421 or the third coil 422 in which the induced electromotive force is generated. For example, the processing circuit may transfer an electrical signal based on the measured value to the processor (e.g., the processor 120 of FIG. 1) disposed on the first circuit board 348. For example, the processor (e.g., the processor 120 of FIG. 1) may detect a click input based on the received electrical signal.

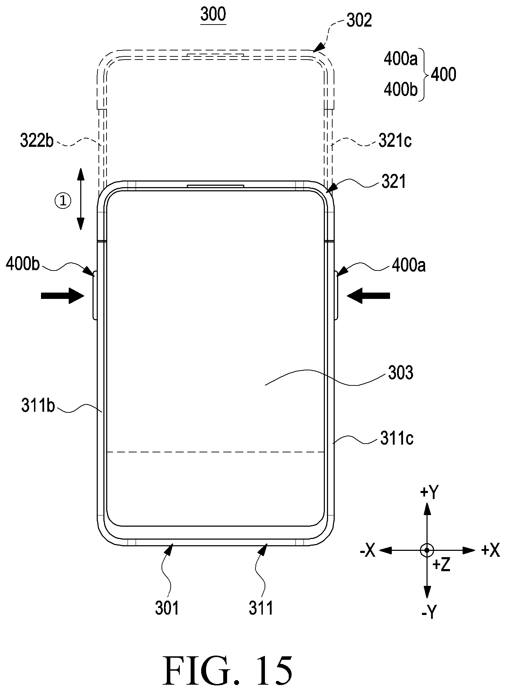

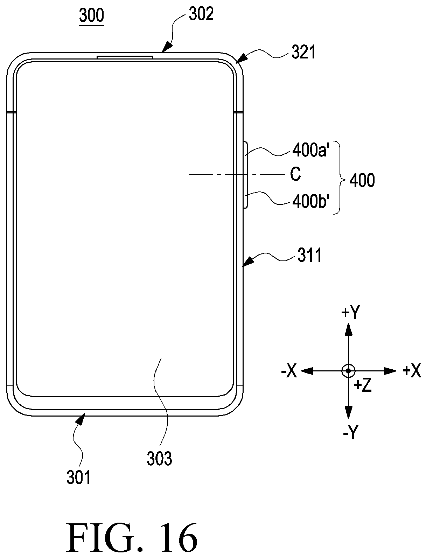

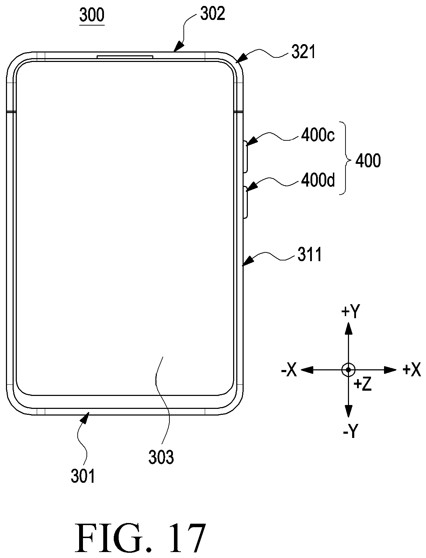

FIG. 15 is a diagram illustrating example operations of a button structure and an electronic device according to various embodiments. FIG. 16 is a diagram illustrating an electronic device including a button structure according to various embodiments. FIG. 17 is a diagram illustrating an electronic device including a button structure according to various embodiments. The embodiments of FIGS. 15 to 17 may be combined with the embodiments of FIGS. 1 to 14.

The configuration of the electronic device 300 of FIGS. 15, 16 and 17 (which may be referred to as FIGS. 15 to 17) may be identical in whole or part to the configuration of the configuration of the electronic device 300 of FIGS. 13A and 14. The configuration of the first cover member 311 and the second cover member 321 of FIGS. 15 to 17 may be identical in whole or part to the configuration of the configuration of the first cover member 311 and the second cover member 321 of FIGS. 13A to 14. The configuration of the button structure 400 of FIGS. 15 to 17 may be identical in whole or part to the configuration of the configuration of the button structure 400 of FIGS. 7, 9, and 14.

Referring to FIG. 15, in an embodiment, the electronic device 300 may include button structures 400 on a plurality of sides of the first housing 301 and the second housing 302. According to an embodiment, the button structures 400 may include a first button structure 400 disposed on the right side (+X direction) of the electronic device 300 and a second button structure 400 disposed on the left side (-X direction) of the electronic device 300. For example, the first button structure 400 may include a first button assembly 410 (e.g., the first button assembly 410 of FIG. 11) disposed on a 1-3th sidewall 311c (e.g., the 1-3th sidewall 311c of FIGS. 13A and 13B) of the first cover member 311 (e.g., the first cover member 311 of FIGS. 13A and 14), and a second button assembly 420 (e.g., the second button assembly 420 of FIG. 12) disposed on a 2-3th sidewall 321c (e.g., the 2-3th sidewall 321c of FIGS. 13A and 13B) of the second cover member 321 (e.g., the second cover member 321 of FIGS. 13A and 14). For example, the second button structure 400 may include a first button assembly 410 (e.g., the first button assembly 410 of FIG. 11) disposed on the 1-2th sidewall 311b of the first cover member 311 and a 2-2th button assembly (e.g., the second button assembly 420 of FIG. 12) disposed on the 2-2th sidewall 322b of the second cover member 321.

According to an embodiment, the first button structure 400 and the second button structure 400 may receive a click input in the directions of the pair of arrows illustrated in FIG. 15. For example, the user may perform a click input by pressing the first button structure 400 and the second button structure 400 substantially simultaneously. According to an embodiment, if the click input is detected by the electronic device 300, the second housing 302 may slide relative to the first housing 301 in the direction of arrow ①. For example, the electronic device 300 may be changed from the slide-in state (indicated by solid line in FIG. 15) to the slide-out state (indicated by dashed line in FIG. 15) by the click input. Conversely, e.g., the electronic device 300 may be changed from the slide-out state (indicated by dashed line in FIG. 15) by the click input to the slide-in state (indicated by solid line in FIG. 15) by the click input. However, the sliding function of the second housing 302 with respect to the first housing 301 is not performed only by the above-described pair of button structures 400a and 400b. For example, a single button structure 400 such as the first button structure 400a or the second button structure 400b may function as a button for sliding of the second housing 302 with respect to the first housing 301.

Referring to FIG. 16, in an embodiment, the electronic device 300 may share one button driver 430, and may include a button structure 400 having a plurality of areas of a click input. According to an embodiment, the button structure 400 may include a first button area 400a' and a second button area 400b' that are divided with respect to a virtual line C. For example, each of the first button area 400a' and the second button area 400b' may individually receive a click input. According to an embodiment, the first button area 400a' and the second button area 400b' may share the first button assembly 410 (e.g., the first button assembly 410 of FIG. 11) disposed on the 1-3th sidewall 311c of the first cover member 311. For example, the button structure 400 may be configured to separate and process the signal of the click input applied to the first button area 400a' and the second button area 400b'. According to an embodiment, the first button area 400a' and the second button area 400b' may share the second button assembly 420 (e.g., the second button assembly 420 of FIG. 12) disposed on the 2-3th sidewall 321c of the second cover member 321.

According to an embodiment, the click input applied to the first button area 400a' and the second button area 400b' may lead to different functions of the electronic device 300. For example, relative positions of the first button area 400a' and the second button area 400b' may be related to the respective functions. For example, the first button area 400a' and the second button area 400b' disposed up (+Y direction) and down (-Y direction) may function as a volume up button and a volume down button, respectively. According to an embodiment, compared to when the relative positions of the first button area 400a' and the second button area 400b' are not related to the function, the user may more intuitively recognize each function of the button area 400a' and 400b'.

Referring to FIG. 17, in an embodiment, the button structure 400 may include a plurality of button structures 400 disposed side by side on one sidewall. According to an embodiment, the button structure 400 may include a third button structure 400c and a fourth button structure 400d disposed on the 1-3th sidewall 311c of the first cover member 311 to be spaced apart from each other in the length direction (e.g., the Y-axis direction) of the sidewall.

According to an embodiment, the third button structure 400c and the fourth button structure 400d may share the second button assembly 420 (e.g., the second button assembly 420 of FIG. 12) disposed on the 2-3th sidewall 321c of the second cover member 321. According to an embodiment, the third button structure 400c and the fourth button structure 400d may share the first button assembly 410 (e.g., the first button assembly 410 of FIG. 11) disposed on the 1-3th sidewall 311c of the first cover member 311. For example, the first button assembly 410 may include a single sensor module 411 and a first coil 412 (e.g., the first coil 412 of FIG. 13B) electrically connected to the sensor module 411. For example, the sensor module 411 may at least partially overlap the button driver 430 (e.g., the button driver 430 of FIGS. 13A and 13B) of the third button structure 400 and the button driver 430 of the fourth button structure 400 with respect to the X-axis direction. For example, the button structure 400 may be configured to separate and process the signal of the click input applied to different areas of the sensor module 411 overlapping the third button structure 400c and the fourth button structure 400d, respectively. However, the number of sensor modules 411 is not limited to one. For example, the first button assembly 410 may include two sensor modules 411 for receiving click inputs applied to the third button structure 400c and the fourth button structure 400d, respectively. For example, the two sensor modules may be electrically connected to at least one first coil 412 (e.g., the first coil 412 of FIG. 13B).

According to an embodiment, the click input applied to the third button structure 400c and the fourth button structure 400d may lead to different functions of the electronic device 300. For example, relative positions of the third button structure 400c and the fourth button structure 400d may be related to the respective functions. For example, the third button structure 400c and the fourth button structure 400d disposed up (+Y direction) and down (-Y direction) may function as a volume up button and a volume down button, respectively. According to an embodiment, compared to when the relative positions of the third button structure 400c and the fourth button structure 400d are not related to the function, the user may more intuitively recognize the functions of the button structures 400c and 400d.

An electronic device (e.g., a portable terminal) may include: a display having a flat surface or a flat surface and a curved surface. An electronic device including a display may have a limitation in realizing a screen larger than the size of the electronic device due to the fixed display structure. Therefore, an electronic device including a rollable display (hereinafter, referred to as a rollable electronic device) has been studied.

The rollable electronic device may have a structure in which the second housing moves with respect to the first housing. In the case of a physical button, the entire button structure may be embedded in a sidewall of the first housing positioned at the outermost side of the rollable electronic device. Accordingly, a mounting space of the button structure may be required in the sidewall of the first housing. This may increase the thickness of the sidewall of the first housing, thereby damaging the aesthetics of the electronic device. Further, if the entire button structure is embedded in the first housing, the wiring structure between the button structure and the main circuit board in the second housing may be complicated. For example, the FPCB connected to the button structure may be connected to the main circuit board in the second housing via an auxiliary circuit board in the first housing. In this case, since the FPCB is connected to the second housing via the first housing, it is required to be configured to be moved or extended in response to a slide of the second housing.

According to various embodiments of the disclosure, there may be provided an electronic device including a button structure capable of reducing the mounting space of the button structure required in one housing by disposing components of the button structure in the respective sidewalls of two housings of the electronic device.

According to various embodiments of the disclosure, there may be provided an electronic device including a button structure capable of simplifying the wiring structure between the button structure and the main circuit board.

According to an example embodiment, an electronic device (e.g., the electronic device 101 of FIG. 1, the electronic device 101, the electronic device 101 of FIGS. 2 to 5B, and/or the electronic device 300 of FIGS. 7, 9, 13A, and 14 to 17) may comprise: a first housing (e.g., the first housing 201 of FIGS. 2 to 4 and/or the first housing 301 of FIGS. 7, 9, and 14 to 17), a second housing (e.g., the second housing 202 of FIGS. 2 to 4 and/or the second housing 302 of FIGS. 7, 9, and 14 to 17), a display (e.g., the display module 160 of FIG. 1, the display 203 of FIGS. 2 to 4, the display 231 of FIGS. 4 to 5B, and/or the display 303 of FIGS. 7, 9, 13A, and 14 to 17), and/or a button structure comprising a button (e.g., the button assembly 245 of FIGS. 2 and 3 and/or the button structure 400 of FIGS. 7, 9, and 15 to 17). The second housing is configured to be slidable relative to the first housing. The display is a rollable display configured to be unrolled or rolled based on the slide of the second housing. The button structure includes a sensor module including at least one sensor (e.g., the sensor module 411 of FIGS. 7 to 11 and 13B), a first coil (e.g., the first coil 412 of FIGS. 7 to 11), a second coil (e.g., the second coil 421 of FIGS. 7 to 10, 12 and 13B), and a third coil (e.g., the third coil 422 of FIGS. 7 to 10 and 12). The first coil is disposed in the first sidewall (e.g., the 1-3th sidewall 211c of FIGS. 2 to 3 and/or the 1-3th sidewall 311c of FIGS. 7 to 11, and FIGS. 13A to 17) and spaced apart from the sensor module and electrically connected to the sensor module. The second coil and the third coil are disposed in a second sidewall (e.g., the 2-3th sidewall 221c of FIGS. 2 to 3 and/or the 2-3th sidewall 321c of FIGS. 7 to 10 and 12 to 17)) of the second housing facing the first sidewall. The second coil is spaced apart from the third coil in a sliding direction of the second housing (e.g., the direction of arrow ① in FIG. 2, the direction of arrow ① in FIG. 15, and/or the Y-axis direction).

In a slide-in state of the electronic device (e.g., the state of the electronic device 101 illustrated in FIGS. 2 and 5A and/or the state of the electronic device 300 illustrated in FIGS. 7, 13A, 16, and 17), the first coil at least partially faces the second coil. In a slide-out state of the electronic device (e.g., the state of the electronic device 101 illustrated in FIGS. 3 and 5B and/or the state of the electronic device 300 illustrated in FIGS. 9 and 14), the first coil least partially faces the third coil.

According to an example embodiment of the disclosure, as the second coil or the third coil may be electromagnetically connected to the first coil in response to a slide of the second housing, the button structure may be configured to be operated in both the slide-in state or the slide-out state of the rollable electronic device.

In an example embodiment, the sensor module may be configured to generate an instantaneous voltage based on an external force being applied to the sensor module. According to an example embodiment, the first coil may be configured to generate a magnetic field when the voltage is applied.

In an example embodiment, the sensor module may include at least one piezoelectric element comprising a piezoelectric material.

According to an example embodiment of the disclosure, using a sensor module including a piezoelectric element in a button structure, it is possible to detect a click input having a relatively tiny force with a higher accuracy than a physical button that primarily transfers the force of a click input through mechanical coupling between components. For example, when the sensor module includes a thin film piezoelectric element, power consumption of the sensor may be reduced compared to a thick film piezoelectric element having a thickness of several tens of µm, and as the mounting space of the sensor is reduced, it may contribute to downsizing and integrating the electronic device.

In an example embodiment, at least a partial area between an outer surface of the first sidewall and the sensor module may be configured to transfer an external force to the sensor module.

In an example embodiment, the button structure may include a button driver (e.g., the button driver 430 of FIGS. 13A and 13B) protruding from a partial area corresponding to the sensor module on the outer surface of the first sidewall.

In an example embodiment, at least one of the second coil or the third coil may be configured to induce a voltage by the magnetic field of the first coil in a state while at least partially facing the first coil.

In an example embodiment, the button structure may include an electronic component comprising circuitry configured to detect a change in a voltage of the second coil and the third coil in the second sidewall and to process the same into an electrical signal.

In an example embodiment, a circuit board (e.g., the first circuit board 248 of FIGS. 4 to 5B and/or the first circuit board 348 of FIG. 14) may be included in the second housing. According to an example embodiment, the circuit board may include at least one processor, comprising processing circuitry (e.g., the processor 120 of FIG. 1), configured to communicate an electrical signal to and from the electronic component. According to an example embodiment, at least one processor, individually and/or collectively, may be configured to detect an input applied to the button structure based on the received electrical signal.

In an example embodiment, the first sidewall may include a first side surface (e.g., the first surface P1 of FIGS. 8 and 10) including an outer surface of the first sidewall and a second side surface (e.g., the first side surface P2 of FIGS. 8 and 10) opposite the first side surface and facing the first sidewall. According to an example embodiment, at least one of the sensor module or the first coil may be further closer to the first side surface than the second side surface.

In an example embodiment, the second sidewall may include a third side surface (e.g., the third side surface P3 of FIGS. 8 and 10) facing the first sidewall and a fourth side surface (e.g., the fourth side surface P4 of FIGS. 8 and 10) opposite the third side surface. According to an example embodiment, at least one of the second coil or the third coil may be closer to the fourth side surface than the third side surface.

In an example embodiment, an air gap may be formed between the first sidewall and the second sidewall.

In an example embodiment, the display may include a first display area (the first display area A1 of FIGS. 2 to 5B) connected to the second housing and a second display area (the second display area A2 of FIGS. 2 to 5B) extending from the first display area. According to an example embodiment, the second display area may be unrolled or rolled based on the slide of the second housing.

In an example embodiment, based on at least one processor detecting the input signal, at least one processor, individually and/or collectively, may be configured to generate a signal that enables the second housing to slide with respect to the first housing.

In an example embodiment, the button structure may include at least one additional coil (not shown) disposed between the second coil and the third coil in the second sidewall. According to an example embodiment, in an intermediate state between the slide-in state and the slide-out state of the electronic device, the first coil may at least partially face the at least one additional coil.

An electronic device (e.g., the electronic device 101 of FIG. 1, the electronic device 101 of FIGS. 2 to 5B, and/or the electronic device 300 of FIGS. 7, 9, 13A, 14 to 17) according to an example embodiment of the disclosure may include: a first housing (e.g., the first housing 201 of FIGS. 2 to 4 and/or the first housing 301 of FIGS. 7, 9, 14 to 17), a second housing (e.g., the second housing 202 of FIGS. 2 to 4 and/or the second housing 302 of FIGS. 7, 9, 14 to 17), a display (e.g., the display module of FIG. 1, the display 203 of FIGS. 2 to 3, the display 231 of FIGS. 4 to 5B, and/or the display 303 of FIGS. 7, 9, 13A, 14 to 17), a first button assembly including a button (e.g., the first button assembly 410 of FIGS. 7 and 9), and/or a second button assembly including a button (e.g., the second button assembly 420 of FIGS. 7 and 9). The second housing is configured to be slidable relative to the first housing. The display includes a rollable display configured to be unrolled or rolled based on the slide of the second housing. The first button assembly may be disposed in a first sidewall (e.g., the 1-3th sidewall 211c of FIGS. 2 to 3 and/or the 1-3th sidewall 311c of FIGS. 7 to 11, and FIGS. 13A to 17) of the first housing. The first button assembly may include a sensor module including at least one sensor (e.g., the sensor module 411 of FIGS. 7 to 11 and 13B) and a first coil (e.g., the first coil 412 of FIGS. 7 to 11). The second button assembly may be disposed in a second sidewall (e.g., the 2-3th sidewall 221c of FIGS. 2 and 3 and/or the 2-3th sidewall 321c of FIGS. 7 to 10, and 12 to 17) of the second housing facing the first sidewall. The second button assembly may include a second coil (e.g., the second coil 421 of FIGS. 7 to 10, 12 and 13B) and a third coil (e.g., the third coil 422 of FIGS. 7 to 10 and 12) spaced apart from the second coil in the sliding direction.

In an example embodiment, in a slide-in state of the electronic device (e.g., the state of the electronic device 101 illustrated in FIGS. 2 and 5A and/or the state of the electronic device 300 illustrated in FIGS. 7, 13A, 16, and 17), the first coil may at least partially face the second coil. According to an example embodiment, in a slide-out state of the electronic device (e.g., the state of the electronic device 101 illustrated in FIGS. 3 and 5B and/or the state of the electronic device 300 illustrated in FIGS. 9 and 14), the first coil may at least partially face the third coil.

In an example embodiment, the sensor module may be configured to generate an instantaneous voltage based on an external force being applied. According to an example embodiment, the first coil may be configured to generate a magnetic field based on the voltage being applied.

In an example embodiment, at least one of the second coil or the third coil may be configured to induce a voltage by the magnetic field of the first coil in a state in which at least a partial area faces the first coil.

In an example embodiment, the electronic device (e.g., the electronic device of FIG. 15) may also include a first button assembly in a third sidewall (e.g., the 1-2th sidewall 211b of FIGS. 2 and 3 and/or the 1-2th sidewall 311b of FIGS. 11, 15 to 17) opposite to the first sidewall of the first housing. According to an example embodiment, the second button assembly may also be included in a fourth sidewall (e.g., the 2-2th sidewall 221b of FIGS. 2 and 3 and/or the 2-2th sidewall 321b of FIGS. 12, 15 to 17) opposite to the second sidewall of the second housing.

According to various example embodiments of the disclosure, as the second button assembly receiving an electrical signal (e.g., a voltage change) by the first button assembly of the first housing is disposed in the second housing that slides with respect to the first housing, the mounting space of the button structure required for the first housing may be reduced as compared to a physical button where substantially the entire button structure is mounted in the first housing. As the mounting space of the button structure is reduced, the thickness of the sidewall of the first housing and the bezel thickness of the electronic device may be reduced, and the outer appearance of the entire electronic device may be enhanced.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used herein, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. **In** such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 300), comprising:
a first housing (201; 301);
a second housing (202; 302) configured to slide relative to the first housing;
a rollable display (160; 203; 231; 303) configured to be unrolled or rolled based on the slide of the second housing; and
a button structure, including a button (245; 400), wherein the button structure includes:
a sensor module including at least one sensor disposed in a first sidewall (211c; 311c) of the first housing;
the electronic device further **characterized by** comprising:
a first coil (412) disposed in the first sidewall and spaced apart from the sensor module and electrically connected to the sensor module; and
a second coil (421) and a third coil (422) disposed in a second sidewall of the second housing, the second sidewall facing the first sidewall,
wherein the second coil is spaced apart from the third coil in a sliding direction of the second housing, and
wherein in a slide-in state of the electronic device, the first coil is configured to at least partially face the second coil, and in a slide-out state of the electronic device, the first coil is configured to at least partially face the third coil.

2. The electronic device of claim 1, wherein the sensor module is configured to generate an instantaneous voltage based on an external force being applied to the sensor module, and wherein the first coil is configured to generate a magnetic field based on the voltage being applied.

3. The electronic device of claim 1 or 2, wherein the sensor module includes at least one piezoelectric element comprising a piezoelectric material.

4. The electronic device of any one of claims 1 to 3, wherein the first sidewall is configured so that at least a partial area between an outer surface of the first sidewall and the sensor module is configured to transfer an external force to the sensor module.

5. The electronic device of any one of claims 1 to 4, wherein in the button structure, an outer surface of the first sidewall further includes a button driver (430) configured to protrude from a partial area corresponding to the sensor module.

6. The electronic device of any one of claims 1 to 5, wherein at least one of the second coil or the third coil is configured to induce a voltage by the magnetic field of the first coil while at least partially facing the first coil.

7. The electronic device of any one of claims 1 to 6, wherein the button structure further includes an electronic component comprising circuitry and disposed in the second sidewall, the electronic component configured to detect a change in a voltage of the second coil and the third coil and to process the change into an electrical signal.

8. The electronic device of claim 7, further comprising a circuit board (248; 348) inside the second housing, wherein the circuit board includes at least one processor, comprising processing circuitry, (120) connected to the electronic component, individually and/or collectively, configured to: to communicate an electrical signal, and detect an input applied to the button structure based on the received electrical signal.

9. The electronic device of any one of claims 1 to 8, wherein the first sidewall includes a first side surface (P1) which is an outer surface of the first sidewall and a second side surface (P2) opposite the first side surface and facing the first sidewall, and wherein at least one of the sensor module or the first coil is closer to the first side surface than the second side surface.

10. The electronic device of any one of claims 1 to 9, wherein the second sidewall includes a third side surface (P3) facing the first sidewall and a fourth side surface (P4) opposite the third side surface, and wherein at least one of the second coil or the third coil is closer to the fourth side surface than the third side surface.

11. The electronic device of any one of claims 1 to 10, wherein an air gap is formed between the first sidewall and the second sidewall.

12. The electronic device of any one of claims 1 to 11, wherein the display includes:
a first display area (A1) connected to the second housing; and
a second display area (A2) extending from the first display area, and wherein the second display area is configured to be unrolled or rolled based on the slide of the second housing.

13. The electronic device of claim 8, wherein at least one processor, individually and/or collectively, is configured to generate a signal to slide the second housing relative to the first housing based on at least one processor detecting an input signal.

14. The electronic device of any one of claims 1 to 13, wherein the button structure further includes at least one additional coil disposed between the second coil and the third coil in the second sidewall, wherein in an intermediate state between the slide-in state and the slide-out state of the electronic device, the first coil at least partially faces the at least one additional coil.

## Patentansprüche

1. Elektronische Vorrichtung (101; 300), umfassend:
ein erstes Gehäuse (201; 301);
ein zweites Gehäuse (202; 302), das dazu konfiguriert ist, relativ zu dem ersten Gehäuse zu gleiten;
eine rollbare Anzeige (160; 203; 231; 303), die dazu konfiguriert ist, basierend auf dem Gleiten des zweiten Gehäuses ausgerollt oder eingerollt zu werden; und
eine Tastenstruktur, die eine Taste (245; 400) enthält, wobei die Tastenstruktur umfasst:
ein Sensormodul, das mindestens einen Sensor beinhaltet, der in einer ersten Seitenwand (211c; 311c) des ersten Gehäuses angeordnet ist;
wobei die elektronische Vorrichtung ferner **dadurch gekennzeichnet ist, dass** sie umfasst:
eine erste Spule (412), die in der ersten Seitenwand angeordnet und von dem Sensormodul beabstandet ist und elektrisch mit dem Sensormodul verbunden ist; und
eine zweite Spule (421) und eine dritte Spule (422), die in einer zweiten Seitenwand des zweiten Gehäuses angeordnet sind, wobei die zweite Seitenwand der ersten Seitenwand zugewandt ist,
wobei die zweite Spule in einer Gleitrichtung des zweiten Gehäuses von der dritten Spule beabstandet ist, und
wobei in einem Einschubzustand der elektronischen Vorrichtung die erste Spule dazu konfiguriert ist, der zweiten Spule zumindest teilweise zugewandt zu sein, und in einem Ausschubzustand der elektronischen Vorrichtung die erste Spule dazu konfiguriert ist, der dritten Spule zumindest teilweise zugewandt zu sein.

2. Elektronische Vorrichtung nach Anspruch 1, wobei das Sensormodul dazu konfiguriert ist, basierend darauf, dass das Sensormodul mit einer externen Kraft beaufschlagt wird, eine momentane Spannung zu erzeugen, und wobei die erste Spule dazu konfiguriert ist, basierend darauf, dass die Spannung angelegt wird, ein Magnetfeld zu erzeugen.

3. Elektronische Vorrichtung nach Anspruch 1 oder 2, wobei das Sensormodul mindestens ein piezoelektrisches Element beinhaltet, das ein piezoelektrisches Material umfasst.

4. Elektronische Vorrichtung nach einem der Ansprüche 1 bis 3, wobei die erste Seitenwand so konfiguriert ist, dass mindestens ein Teilbereich zwischen einer Außenfläche der ersten Seitenwand und dem Sensormodul dazu konfiguriert ist, eine externe Kraft auf das Sensormodul zu übertragen.

5. Elektronische Vorrichtung nach einem der Ansprüche 1 bis 4, wobei in der Tastenstruktur eine Außenfläche der ersten Seitenwand ferner einen Tastenantrieb (430) beinhaltet, der dazu konfiguriert ist, aus einem Teilbereich, der dem Sensormodul entspricht, vorzustehen.

6. Elektronische Vorrichtung nach einem der Ansprüche 1 bis 5, wobei mindestens eine der zweiten Spule oder der dritten Spule dazu konfiguriert ist, durch das Magnetfeld der ersten Spule eine Spannung zu induzieren, während sie der ersten Spule zumindest teilweise zugewandt ist.

7. Elektronische Vorrichtung nach einem der Ansprüche 1 bis 6, wobei die Tastenstruktur ferner eine elektronische Komponente beinhaltet, die eine Schaltung umfasst und in der zweiten Seitenwand angeordnet ist, wobei die elektronische Komponente dazu konfiguriert ist, eine Änderung einer Spannung der zweiten Spule und der dritten Spule zu erfassen und die Änderung zu einem elektrischen Signal zu verarbeiten.

8. Elektronische Vorrichtung nach Anspruch 7, ferner umfassend eine Schaltplatte (248; 348) innerhalb des zweiten Gehäuses, wobei die Schaltplatte mindestens einen Prozessor, der eine Verarbeitungsschaltung umfasst, (120) beinhaltet, der mit der elektronischen Komponente verbunden ist und einzeln und/oder gemeinsam konfiguriert ist zum: Kommunizieren eines elektrischen Signals und Erfassen einer auf die Tastenstruktur angewendeten Eingabe basierend auf dem empfangenen elektrischen Signal.

9. Elektronische Vorrichtung nach einem der Ansprüche 1 bis 8, wobei die erste Seitenwand eine erste Seitenfläche (P1), die eine Außenfläche der ersten Seitenwand ist, und eine zweite Seitenfläche (P2) beinhaltet, die der ersten Seitenfläche gegenüberliegt und der ersten Seitenwand zugewandt ist, und wobei mindestens eines von dem Sensormodul oder der ersten Spule näher an der ersten Seitenfläche als an der zweiten Seitenfläche liegt.

10. Elektronische Vorrichtung nach einem der Ansprüche 1 bis 9, wobei die zweite Seitenwand eine dritte Seitenfläche (P3), die der ersten Seitenwand zugewandt ist, und eine vierte Seitenfläche (P4) beinhaltet, die der dritten Seitenfläche gegenüberliegt, und wobei mindestens eine der zweiten Spule oder der dritten Spule näher an der vierten Seitenfläche als an der dritten Seitenfläche liegt.

11. Elektronische Vorrichtung nach einem der Ansprüche 1 bis 10, wobei zwischen der ersten Seitenwand und der zweiten Seitenwand ein Luftspalt ausgebildet ist.

12. Elektronische Vorrichtung nach einem der Ansprüche 1 bis 11, wobei die Anzeige umfasst:
einen ersten Anzeigebereich (A1), der mit dem zweiten Gehäuse verbunden ist; und
einen zweiten Anzeigebereich (A2), der sich von dem ersten Anzeigebereich erstreckt, und wobei der zweite Anzeigebereich dazu konfiguriert ist, basierend auf dem Gleiten des zweiten Gehäuses ausgerollt oder eingerollt zu werden.

13. Elektronische Vorrichtung nach Anspruch 8, wobei mindestens ein Prozessor einzeln und/oder gemeinsam dazu konfiguriert ist, basierend darauf, dass mindestens ein Prozessor ein Eingangssignal erfasst, ein Signal zum Gleiten des zweiten Gehäuses relativ zu dem ersten Gehäuse zu erzeugen.

14. Elektronische Vorrichtung nach einem der Ansprüche 1 bis 13, wobei die Tastenstruktur ferner mindestens eine zusätzliche Spule beinhaltet, die zwischen der zweiten Spule und der dritten Spule in der zweiten Seitenwand angeordnet ist, wobei in einem Zwischenzustand zwischen dem Einschubzustand und dem Ausschubzustand der elektronischen Vorrichtung die erste Spule der mindestens einen zusätzlichen Spule zumindest teilweise zugewandt ist.

## Revendications

1. Dispositif électronique (101 ; 300), comprenant :
un premier boîtier (201 ; 301) ;
un deuxième boîtier (202; 302) configuré pour coulisser par rapport au premier boîtier ;
un affichage enroulable (160; 203; 231; 303) configuré pour être déroulé ou enroulé sur la base du coulissement du deuxième boîtier ; et
une structure de bouton, comprenant un bouton (245; 400), la structure de bouton comprenant :
un module de capteur comprenant au moins un capteur disposé dans une première paroi latérale (211c; 311c) du premier boîtier ;
le dispositif électronique étant en outre **caractérisé en ce qu'**il comprend :
une première bobine (412) disposée dans la première paroi latérale et espacée du module de capteur et connectée électriquement au module de capteur ; et
une deuxième bobine (421) et une troisième bobine (422) disposées dans une deuxième paroi latérale du deuxième boîtier, la deuxième paroi latérale faisant face à la première paroi latérale,
dans lequel la deuxième bobine est espacée de la troisième bobine dans une direction de coulissement du deuxième boîtier, et
dans lequel, dans un état rétracté du dispositif électronique, la première bobine est configurée pour faire au moins partiellement face à la deuxième bobine, et, dans un état déployé du dispositif électronique, la première bobine est configurée pour faire au moins partiellement face à la troisième bobine.

2. Dispositif électronique de la revendication 1, dans lequel le module de capteur est configuré pour générer une tension instantanée sur la base d'une force externe appliquée au module de capteur, et dans lequel la première bobine est configurée pour générer un champ magnétique sur la base de la tension appliquée.

3. Dispositif électronique de la revendication 1 ou 2, dans lequel le module de capteur comprend au moins un élément piézoélectrique comprenant un matériau piézoélectrique.

4. Dispositif électronique de l'une quelconque des revendications 1 à 3, dans lequel la première paroi latérale est configurée de sorte qu'au moins une zone partielle entre une surface extérieure de la première paroi latérale et le module de capteur est configurée pour transférer une force externe au module de capteur.

5. Dispositif électronique de l'une quelconque des revendications 1 à 4, dans lequel, dans la structure de bouton, une surface extérieure de la première paroi latérale comprend en outre un actionneur de bouton (430) configuré pour faire saillie à partir d'une zone partielle correspondant au module de capteur.

6. Dispositif électronique de l'une quelconque des revendications 1 à 5, dans lequel au moins l'une de la deuxième bobine ou de la troisième bobine est configurée pour induire une tension par le champ magnétique de la première bobine tout en faisant au moins partiellement face à la première bobine.

7. Dispositif électronique de l'une quelconque des revendications 1 à 6, dans lequel la structure de bouton comprend en outre un composant électronique comprenant un circuit et disposé dans la deuxième paroi latérale, le composant électronique étant configuré pour détecter un changement d'une tension de la deuxième bobine et de la troisième bobine et pour traiter le changement en un signal électrique.

8. Dispositif électronique de la revendication 7, comprenant en outre une carte de circuit imprimé (248; 348) à l'intérieur du deuxième boîtier, dans lequel la carte de circuit imprimé comprend au moins un processeur, comprenant un circuit de traitement, (120) connecté au composant électronique, individuellement et/ou collectivement, configuré pour : communiquer un signal électrique, et détecter une entrée appliquée à la structure de bouton sur la base du signal électrique reçu.

9. Dispositif électronique de l'une quelconque des revendications 1 à 8, dans lequel la première paroi latérale comprend une première surface latérale (P1) qui est une surface extérieure de la première paroi latérale et une deuxième surface latérale (P2) opposée à la première surface latérale et faisant face à la première paroi latérale, et dans lequel au moins l'un du module de capteur ou de la première bobine est plus proche de la première surface latérale que de la deuxième surface latérale.

10. Dispositif électronique de l'une quelconque des revendications 1 à 9, dans lequel la deuxième paroi latérale comprend une troisième surface latérale (P3) faisant face à la première paroi latérale et une quatrième surface latérale (P4) opposée à la troisième surface latérale, et dans lequel au moins l'une de la deuxième bobine ou de la troisième bobine est plus proche de la quatrième surface latérale que de la troisième surface latérale.

11. Dispositif électronique de l'une quelconque des revendications 1 à 10, dans lequel un entrefer est formé entre la première paroi latérale et la deuxième paroi latérale.

12. Dispositif électronique de l'une quelconque des revendications 1 à 11, dans lequel l'affichage comprend :
une première zone d'affichage (A1) connectée au deuxième boîtier ; et
une deuxième zone d'affichage (A2) s'étendant à partir de la première zone d'affichage, et dans lequel la deuxième zone d'affichage est configurée pour être déroulée ou enroulée sur la base du coulissement du deuxième boîtier.

13. Dispositif électronique de la revendication 8, dans lequel au moins un processeur, individuellement et/ou collectivement, est configuré pour générer un signal pour faire coulisser le deuxième boîtier par rapport au premier boîtier sur la base du fait qu'au moins un processeur détecte un signal d'entrée.

14. Dispositif électronique de l'une quelconque des revendications 1 à 13, dans lequel la structure de bouton comprend en outre au moins une bobine supplémentaire disposée entre la deuxième bobine et la troisième bobine dans la deuxième paroi latérale, dans lequel, dans un état intermédiaire entre l'état rétracté et l'état déployé du dispositif électronique, la première bobine fait au moins partiellement face à l'au moins une bobine supplémentaire.
